# EUROPEAN PATENT APPLICATION

(11) **EP 4 715 875 A1**
(43) Date of publication of application: **25.03.2026**
(21) Application number: 25176758.8
(22) Date of filing: 15.05.2025
(51) Int. Cl.: H01L 23/532, H01L 21/768, H01L 23/522, H01L 23/528

(54) **SEMICONDUCTOR DEVICE**

(30) Priority: 20.09.2024 KR 20240127413
(71) Applicant: Samsung Electronics Co., Ltd., Suwon-si, Gyeonggi-do 16677 (KR)
(72) Inventor: KIM, Seonhee, 16677 Suwon-si (KR); KIM, Guanwoo, 16677 Suwon-si (KR); YOO, Seungyong, 16677 Suwon-si (KR); JUNG, Eun-Ji, 16677 Suwon-si (KR); HONG, Wonhyuk, 16677 Suwon-si (KR)
(74) Representative: Marks & Clerk LLP

(57) **Abstract**

A semiconductor device including a transistor on a substrate, the transistor including a conductive pattern; a first metal layer on the transistor, the first metal layer including a first wiring line and a first via below the first wiring line; and an etching stop layer between the transistor and the first metal layer. The first via penetrates the etching stop layer and connects the conductive pattern and the first wiring line. The first via includes a first barrier pattern, a second barrier pattern on the first barrier pattern, and a side barrier pattern between the second barrier pattern and the etching stop layer. The side barrier pattern includes a transition metal oxide.

## Description

### BACKGROUND

The inventive concepts relate to semiconductor devices and methods of manufacturing the same and, more specifically, relates to semiconductor devices including a field effect transistor. and methods of manufacturing the same.

A semiconductor device may include an integrated circuit including metal-oxide-semiconductor field effect transistors (MOSFETs). As sizes and design rules of semiconductor devices have been reduced, sizes of MOSFETs have also been scaled down. Operating characteristics of semiconductor devices may be deteriorated by the scaling down of the MOSFETs. Thus, various research is being conducted directed to semiconductor devices capable of overcoming limitations caused by a high integration density and capable of improving performance.

### SUMMARY

Objects of the inventive concepts include providing a semiconductor device with improved reliability.

Objects of the inventive concepts further include providing a semiconductor device with improved electrical characteristics.

Some example embodiments of the inventive concepts provide a semiconductor device that includes a transistor on a substrate, the transistor including a conductive pattern; a first metal layer on the transistor, the first metal layer including a first wiring line and a first via below the first wiring line; and an etching stop layer between the transistor and the first metal layer. The first via penetrates the etching stop layer, and the first via connects the conductive pattern and the first wiring line. The first via includes a first barrier pattern, a second barrier pattern on the first barrier pattern, and a side barrier pattern between the second barrier pattern and the etching stop layer. The side barrier pattern includes a transition metal oxide.

Some example embodiments of the inventive concepts further provide a semiconductor device that includes a transistor on a substrate, the transistor including a conductive pattern; a first metal layer on the transistor; and an etching stop layer between the transistor and the first metal layer. The first metal layer includes a first wiring line and a first via below the first wiring line. The first via penetrates the etching stop layer, and the first via connects the conductive pattern and the first wiring line. The first via includes a first transition metal. A concentration of the first transition metal increases toward the etching stop layer, and the concentration of the first transition metal has a maximum value at an interface between the first via and the etching stop layer.

Some example embodiments of the inventive concepts still further provide a semiconductor device that includes a substrate including an active pattern; a source/drain pattern on the active pattern; a channel pattern on the active pattern, the channel pattern being connected to the source/drain pattern, and the channel pattern including a plurality of semiconductor patterns that are stacked and spaced apart from each other; a gate electrode extending in a first direction across the channel pattern; a gate insulating layer between the channel pattern and the gate electrode; a gate spacer on a sidewall of the gate electrode; a gate capping pattern on an upper surface of the gate electrode; a first interlayer insulating layer on the gate capping pattern; an active contact penetrating the first interlayer insulating layer, the active contact being connected to the source/drain pattern; a gate contact penetrating the first interlayer insulating layer, the gate contact being connected the gate electrode; an etching stop layer on the first interlayer insulating layer; a second interlayer insulating layer on the etching stop layer; and a first metal layer in the second interlayer insulating layer. The first metal layer includes a first wiring line and a first via below the first wiring line. The first via connects the active contact to the first metal layer. The first via includes a first barrier pattern, a second barrier pattern on the first barrier pattern, and a side barrier pattern between the second barrier pattern and the etching stop layer. The side barrier pattern is a transition metal oxide including a transition metal different than transition metals of each of the first and second barrier patterns.

At least some of the above and other features of the invention are set out in the claims.

### BRIEF DESCRIPTION OF THE DRAWINGS

Some example embodiments will be more clearly understood from the following brief description taken in conjunction with the accompanying drawings. The accompanying drawings represent non-limiting example embodiments as described herein.
FIGS. 1, 2 and 3 are conceptual diagrams illustrating logic cells of a semiconductor device according to some example embodiments of the inventive concepts.
FIG. 4 is a plan view for illustrating a semiconductor device according to some example embodiments of the inventive concepts.
FIGS. 5A is a cross-sectional view taken along line A-A' of FIG. 4.
FIGS. 5B is a cross-sectional view taken along line B-B' of FIG. 4.
FIGS. 5C is a cross-sectional view taken along line C-C' of FIG. 4.
FIGS. 5D is a cross-sectional view taken along line D-D' of FIG. 4.
FIG. 6A is an enlarged view illustrating region 'M' of FIG. 5C.
FIG. 6B is an enlarged view illustrating region 'N' of FIG. 6A and a graph illustrating a concentration of a transition metal in an X direction.
FIGS. 7A, 7B, 8A, 8B, 9A, 9B, 9C, 10A, 10B, 10C, 11A, 11B, 11C, 11D, 12A, 12B, 12C, 12D, 13A, 13B, and 13C are cross-sectional views illustrating a method of manufacturing a semiconductor device according to some example embodiments of the inventive concepts.
FIGS. 14, 15, 16, and 17A are enlarged views illustrating a method of forming region 'M' of FIG. 13C.
FIG. 17B is an enlarged view illustrating region 'N' of FIG. 17A.

### DETAILED DESCRIPTION

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Also, for example, "at least one of A, B, and C" and similar language (e.g., "at least one selected from the group consisting of A, B, and C") may be construed as A only, B only, C only, or any combination of two or more of A, B, and C, such as, for instance, ABC, AB, BC, and AC.

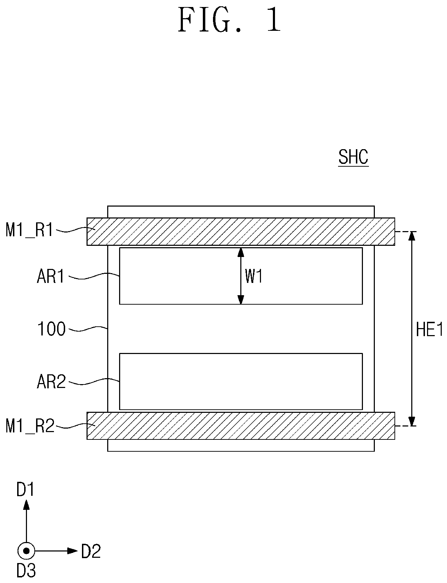

FIGS. 1 to 3 are conceptual diagrams illustrating logic cells of semiconductor devices according to some example embodiments of the inventive concepts.

Referring to FIG. 1, a single height cell SHC may be provided. For example, a substrate 100 may be provided thereon with a first power line M1_R1 and a second power line M1_R2. The first power line M1_R1 may be a path for providing a source voltage VSS, for example, a ground voltage. The second power line M1_R2 may be a path for providing a drain voltage VDD, for example, a power voltage.

The single height cell SHC may be defined between the first power line M1_R1 and the second power line M1_R2. The single height cell SHC may include one first active region AR1 and one second active region AR2. One of the first and second active regions AR1 and AR2 may be a PMOSFET region, and the other of the first and second active regions AR1 and AR2 may be an NMOSFET region. For example, the single height cell SHC may have a complementary metal oxide semiconductor (CMOS) structure provided between the first power line M1_R1 and the second power line M1_R2.

Each of the first and second active regions AR1 and AR2 may have a first width W1 in a first direction D1. A first height HE1 may indicate a length in the first direction D1 of the single height cell SHC. The first height HE1 may be the same or substantially the same as a distance (e.g., pitch) between the first power line M1_R1 and the second power line M1_R2.

The single height cell SHC may constitute one logic cell. In this description, the logic cell may be a logic device, such as AND, OR, XOR, XNOR, and an inverter, that performs a specific function. That is, the logic cell may include transistors for constituting a logic device, and may also include wiring lines that connect the transistors to each other.

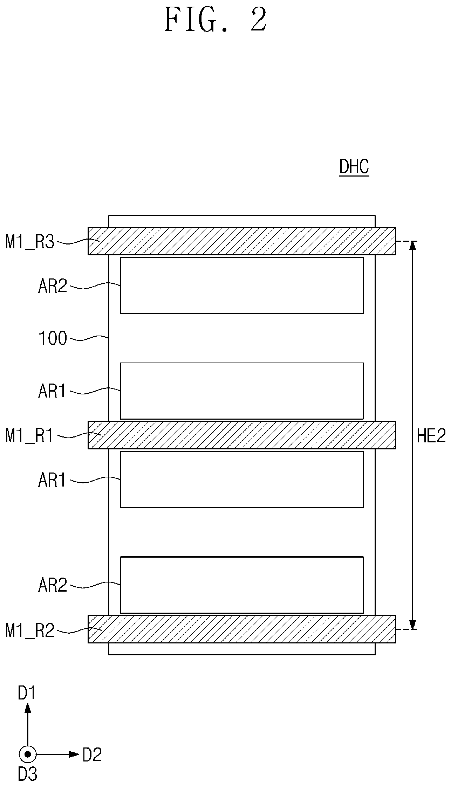

Referring to FIG. 2, a double height cell DHC may be provided. For example, a substrate 100 may be provided thereon with a first power line M1_R1, a second power line M1_R2, and a third power line M1_R3. The first power line M1_R1 may be disposed between the second power line M1_R2 and the third power line M1_R3. The third power line M1_R3 may be a path for providing a source voltage VSS.

The double height cell DHC may be between the second power line M1_R2 and the third power line M1_R3. The double height cell DHC may include two first active regions AR1 and two second active regions AR2.

One of the two second active regions AR2 may be adjacent to the second power line M1_R2. The other of the two second active regions AR2 may be adjacent to the third power line M1_R3. The two first active regions AR1 may be adjacent to the first power line M1_R1. When viewed in a plan view, the first power line M1_R1 may be disposed between the two first active regions AR1.

A second height HE2 may indicate a length in the first direction D1 of the double height cell DHC. The second height HE2 may be about twice the first height HE1 of FIG. 1. The two first active regions AR1 of the double height cell DHC may be integrally connected to each other to serve as one active region.

In the inventive concepts, the double height cell DHC shown in FIG. 2 may be a multi-height cell. The multi-height cell may include a triple height cell whose cell height is about three times that of the single height cell SHC.

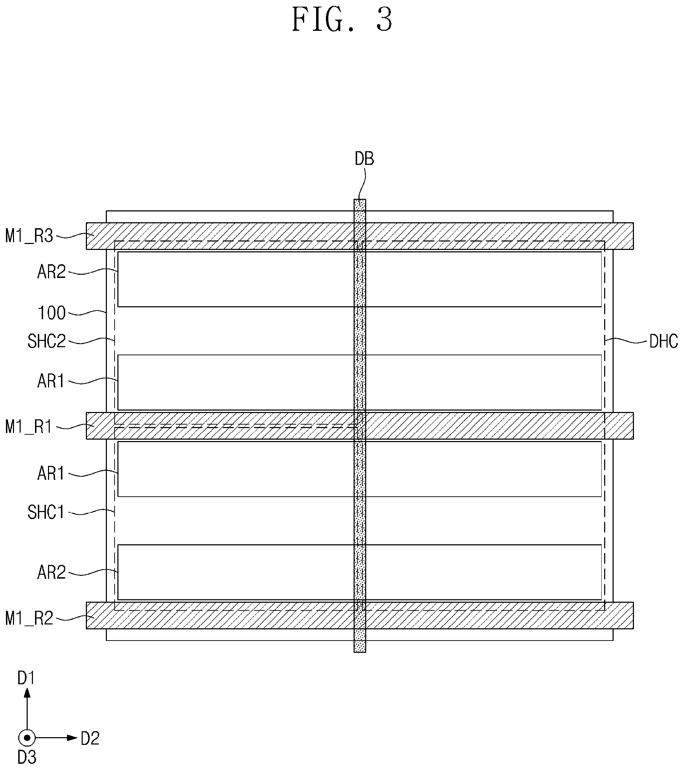

Referring to FIG. 3, a substrate 100 may be provided thereon with a first single height cell SHC1, a second single height cell SHC2, and a double height cell DHC that are two-dimensionally disposed. The first single height cell SHC1 may be disposed between a first power line M1_R1 and a second power line M1_R2. The second single height cell SHC2 may be disposed between the first power line M1_R1 and a third power line M1_R3. The second single height cell SHC2 may be adjacent in a first direction D1 to the first single height cell SHC1.

The double height cell DHC may be disposed between the second power line M1_R2 and the third power line M1_R3. The double height cell DHC may be adjacent in a second direction D2 to the first and second single height cells SHC1 and SHC2.

A separation structure DB may be provided between the first single height cell SHC1 and the double height cell DHC and between the second single height cell SHC2 and the double height cell DHC. The separation structure DB may electrically separate an active region of the double height cell DHC from an active region of each of the first and second single height cells SHC1 and SHC2.

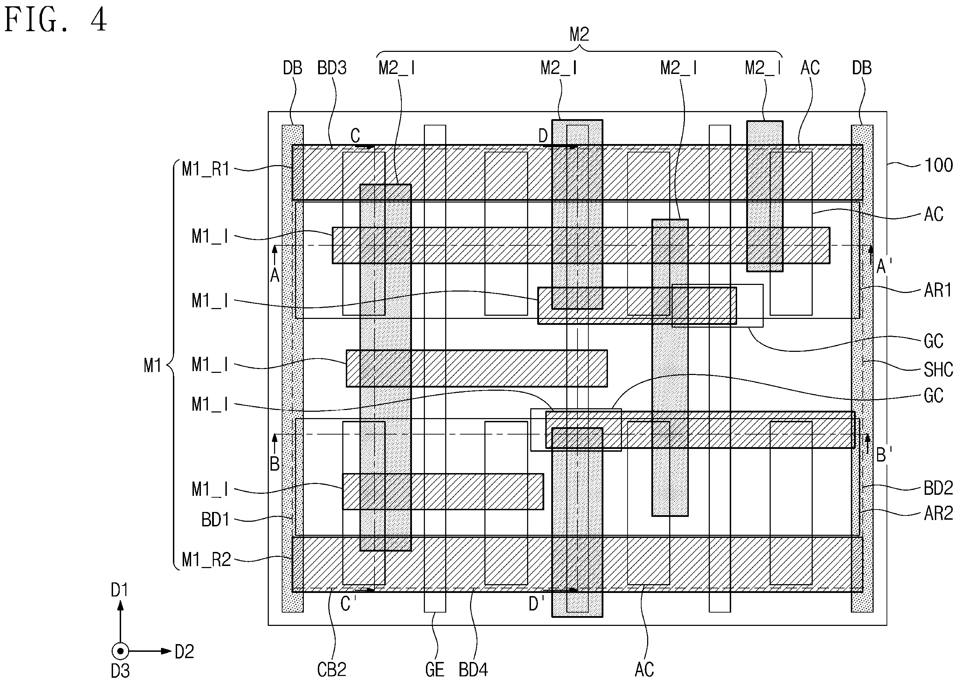

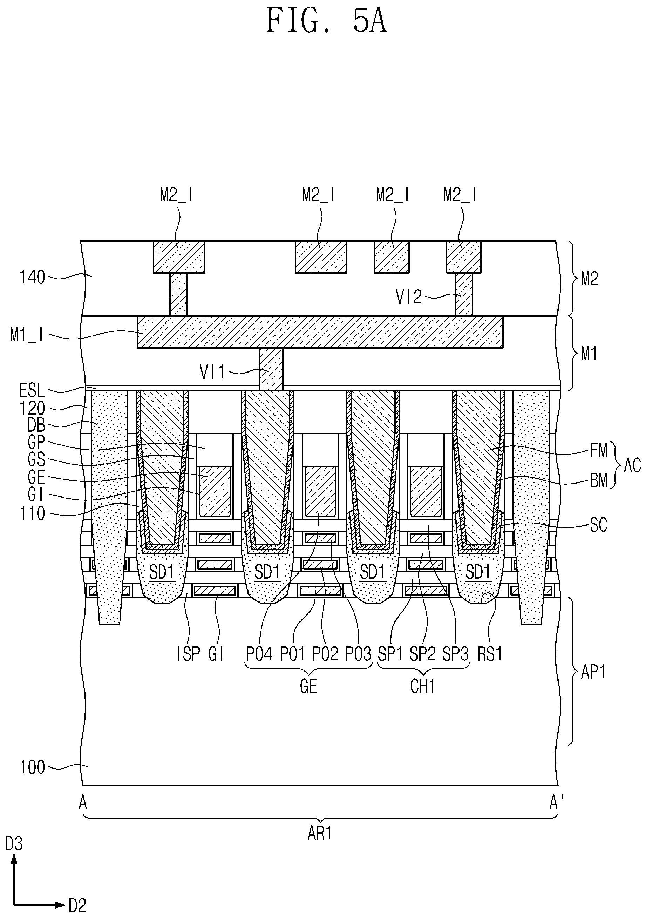

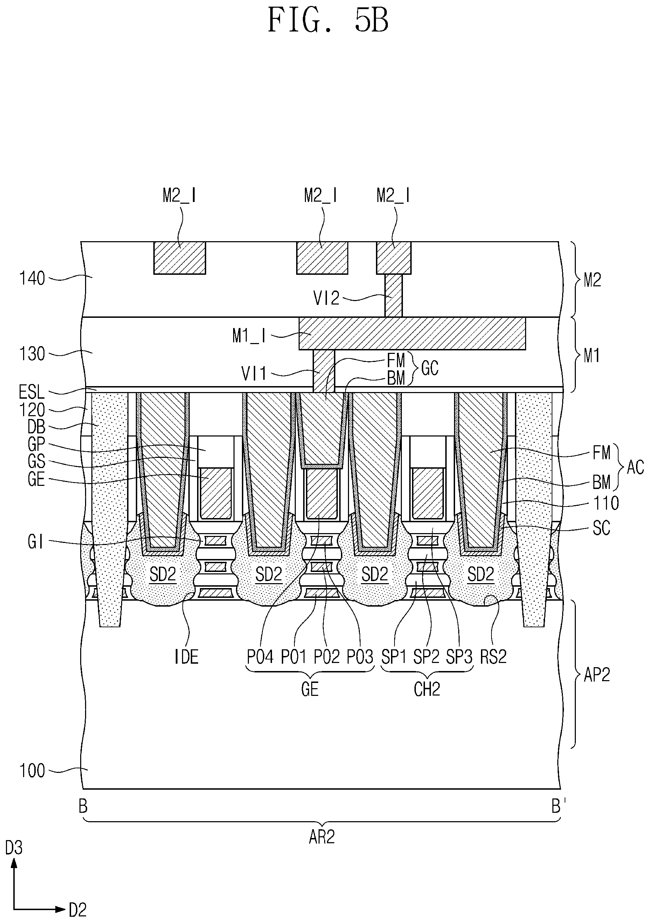

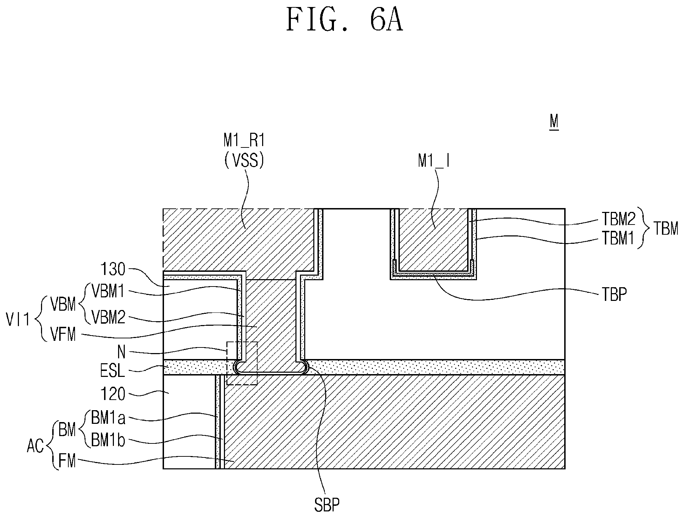

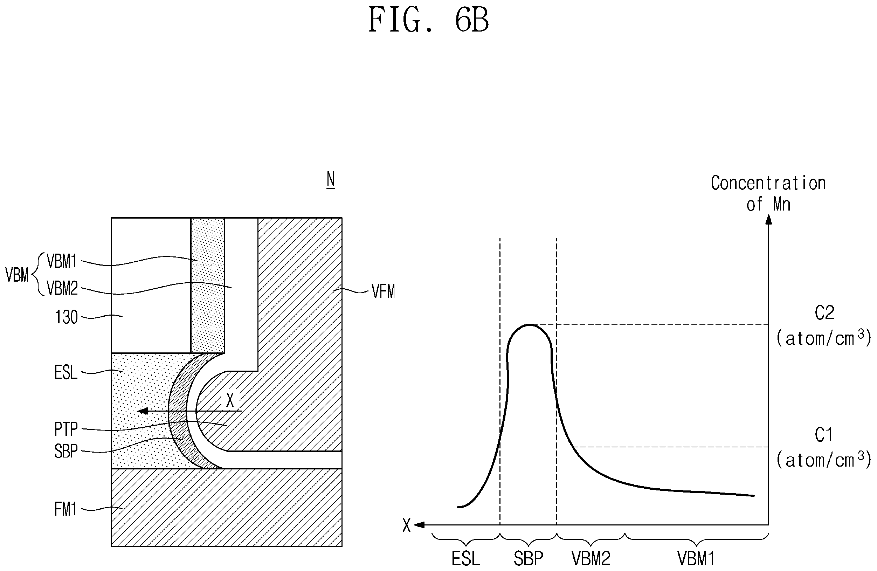

FIG. 4 is a plan view illustrating a semiconductor device according to some example embodiments of the inventive concepts. FIGS. 5A to 5D are cross-sectional views taken along lines A-A', B-B', C-C', and D-D' of FIG. 4, respectively. FIG. 6 is an enlarged view illustrating region 'M' of FIG. 5B. A semiconductor device shown in FIGS. 4 and 5A to 5D is an example of the single height cell SHC depicted in FIG. 1.

Referring to FIGS. 4 and 5A to 5D, a single height cell SHC may be provided on a substrate 100. The single height cell SHC may be provided on the substrate 100 with logic transistors included in a logic circuit. The substrate 100 may be a compound semiconductor substrate or a semiconductor substrate including, for example, silicon, germanium, or silicon-germanium. For example, the substrate 100 may be a silicon substrate.

The substrate 100 may include a first active region AR1 and a second active region AR2. Each of the first and second active regions AR1 and AR2 may extend in a second direction D2. In some example embodiments, the first active region AR1 may be a NMOSFET region, and the second active region AR2 may be an PMOSFET region.

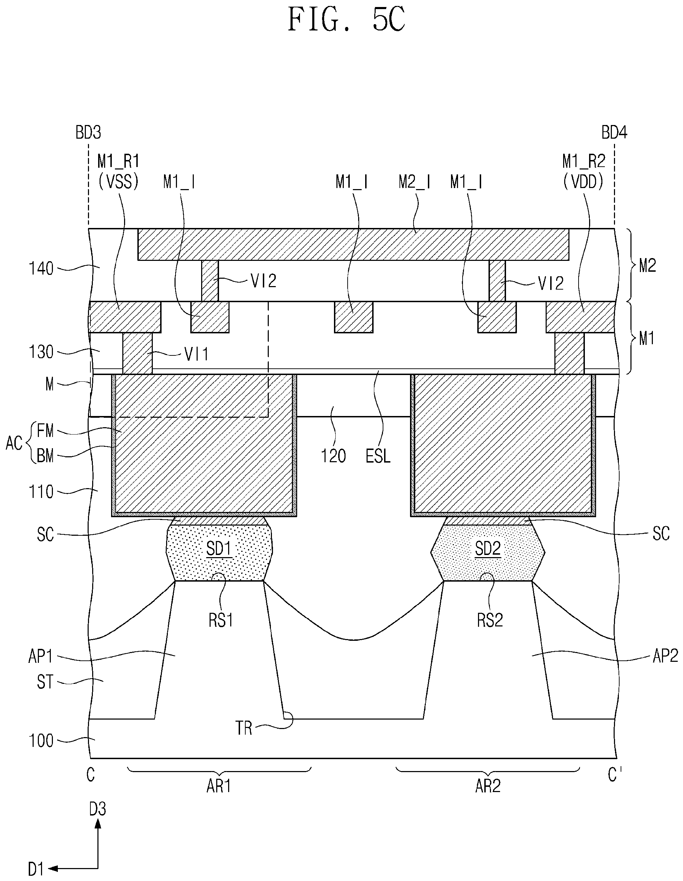

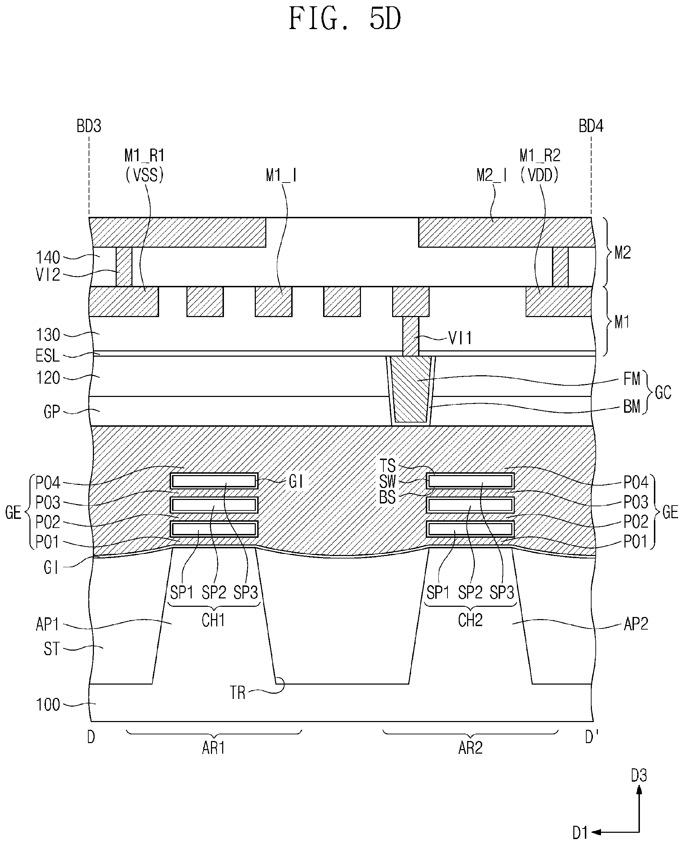

A first active pattern AP1 and a second active pattern AP2 may be defined by a trench TR that is formed on an upper portion of the substrate 100 (e.g., see FIGS. 5C and 5D). The first active pattern AP1 may be provided on the first active region AR1, and the second active pattern AP2 may be provided on the second active region AR2. The first and second active patterns AP1 and AP2 may extend in the second direction D2. The first and second active patterns AP1 and AP2 may be vertically protruding portions of the substrate 100.

A device isolation layer ST may be provided on the substrate 100. The device isolation layer ST may fill the trench TR. The device isolation layer ST may include, for example, a silicon oxide layer. The device isolation layer ST may not cover the first and second channel patterns CH1 and CH2 which will be discussed below.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3 that are sequentially stacked on each other. The first, second, and third semiconductor patterns SP1, SP2, and SP3 may be spaced apart from each other in a vertical direction (e.g., a third direction D3).

Each of the first, second, and third semiconductor patterns SP1, SP2, and SP3 may include silicon (Si), germanium (Ge), and silicon-germanium (SiGe). For example, each of the first, second, and third semiconductor patterns SP1, SP2, and SP3 may include crystalline silicon, for example, single-crystal silicon. In some example embodiments of the inventive concepts, the first to third semiconductor patterns SP1, SP2, and SP3 may be stacked nanosheets.

A plurality of first source/drain patterns SD1 may be provided on the first active pattern AP1. A plurality of first recesses RS1 may be formed on an upper portion of the first active pattern AP1. The first source/drain patterns SD1 may be correspondingly provided in the first recesses RS1. The first source/drain patterns SD1 may be impurity regions of a first conductivity type (e.g., n-type). The first channel pattern CH1 may be interposed between a pair of first source/drain patterns SD1. For example, the pair of first source/drain patterns SD1 may be connected to each other through the stacked first, second, and third semiconductor patterns SP1, SP2, and SP3.

A plurality of second source/drain patterns SD2 may be provided on the second active pattern AP2. A plurality of second recesses RS2 may be formed on an upper portion of the second active pattern AP2. The second source/drain patterns SD2 may be correspondingly provided in the second recesses RS2. The second source/drain patterns SD2 may be impurity regions of a second conductivity type (e.g., p-type). The second channel pattern CH2 may be interposed between a pair of second source/drain patterns SD2. For example, the pair of second source/drain patterns SD2 may be connected to each other through the stacked first, second, and third semiconductor patterns SP1, SP2, and SP3.

The first and second source/drain patterns SD1 and SD2 may be epitaxial patterns formed by a selective epitaxial growth process. For example, each of the first and second source/drain patterns SD1 and SD2 may have an upper surface at a level greater than that of the third semiconductor pattern SP3. For another example, at least one of the first and second source/drain patterns SD1 and SD2 may have an upper surface positioned at the same or substantially the same level as that of an upper surface of the third semiconductor pattern SP3.

In some example embodiments of the inventive concepts, the first source/drain patterns SD1 may include the same semiconductor element (e.g., Si) as that of the substrate 100. The second source/drain patterns SD2 may include a semiconductor element (e.g., SiGe) whose lattice constant is greater than that of a semiconductor element of the substrate 100. Therefore, a pair of second source/drain patterns SD2 may provide a compressive stress to the second channel pattern CH2 therebetween.

In some example embodiments of the inventive concepts, the second source/drain pattern SD2 may have a sidewall having a rugged embossed shape. For example, the second source/drain pattern SD2 may have a sidewall with a wavelike profile. The sidewall of the second source/drain pattern SD2 may protrude toward first, second, and third portions PO1, PO2, and PO3 of a gate electrode GE which will be discussed below.

Gate electrodes GE may be provided on the first and second channel patterns CH1 and CH2. Each of the gate electrodes GE may be provided to extend in the first direction D1 and to extend across the first and second channel patterns CH1 and CH2. Each of the gate electrodes GE may vertically overlap the first and second channel patterns CH1 and CH2. The gate electrodes GE may be arranged at a first pitch in the second direction D2.

The gate electrode GE may include a first portion PO1 interposed between the first semiconductor pattern SP1 and the active pattern AP1 or AP2, a second portion PO2 interposed between the first semiconductor pattern SP1 and the second semiconductor pattern SP2, a third portion PO3 interposed between the second semiconductor pattern SP2 and the third semiconductor pattern SP3, and a fourth portion PO4 disposed on the third semiconductor pattern SP3.

Referring to FIG. 5D, the gate electrode GE may be provided on an upper surface TS, a bottom surface BS, and opposite sidewalls SW of each of the first, second, and third semiconductor patterns SP1, SP2, and SP3. For example, a transistor according to some example embodiments may be a three-dimensional field effect transistor (e.g., MBCFET or GAAFET) in which the gate electrode GE three-dimensionally surrounds the first and second channel patterns CH1 and CH2.

Inner spacers ISP may be interposed between the first to third portions PO1, PO2, and PO3 of the gate electrode GE and the first source/drain pattern SD1 on the first active region AR1. Each of the first to third portions PO1, PO2, and PO3 of the gate electrode GE may be spaced apart from the first source/drain pattern SD1 with the inner spacer ISP interposed therebetween. The inner spacer ISP may limit and/or prevent leakage current from the gate electrode GE.

Referring to FIGS. 4 and 5A to 5D, a pair of gate spacers GS may be respectively arranged on opposite sidewalls of the outer electrode PO4 of the gate electrode GE. The gate spacers GS may extend in the first direction D1 along the gate electrode GE. In some example embodiments, the gate spacers GS may include at least one of SiCN, SiCON, and SiN. In some example embodiments, the gate spacers GS may include a multi-layer formed of at least two of SiCN, SiCON, and SiN. In some example embodiments of the inventive concepts, the gate spacer GS may include a Si-containing insulating material. The gate spacer GS may function as an etching stop layer during forming active contact structures AC (e.g., FIG. 4) to be described later. The active contact structures AC (e.g., FIG. 4) may be formed in a self-aligned manner by the gate spacer GS.

A gate capping pattern GP may be provided on the gate electrode GE. The gate capping pattern GP may extend in the first direction D1 along the gate electrode GE. The gate capping pattern GP may include a material having an etch selectivity with respect to first and second interlayer dielectric layers 110 and 120 which will be discussed below. For example, the gate capping pattern GP may include at least one of, for example, SiON, SiCN, SiCON, and SiN.

A gate dielectric layer GI may be interposed between the gate electrode GE and the first channel pattern CH1 and between the gate electrode GE and the second channel pattern CH2. The gate dielectric layer GI may cover an upper surface TS, a bottom surface BS, and opposite sidewalls SW of each of the first, second, and third semiconductor patterns SP1, SP2, and SP3. The gate dielectric layer GI may cover an upper surface of the device isolation layer ST that is below the gate electrode GE.

In some example embodiments of the inventive concepts, the gate insulating layer GI may include a silicon oxide layer, a silicon oxynitride layer, and/or a high-k dielectric layer. For example, the gate insulating layer GI may have a structure in which a silicon oxide layer and a high-k dielectric layer are stacked. The high-k dielectric layer may include a high-k dielectric material whose dielectric constant is greater than that of a silicon oxide layer. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

In some example embodiments, the semiconductor device of the inventive concepts may include a negative capacitance field effect transistor that uses a negative capacitor. For example, the gate dielectric layer GI may include a ferroelectric material layer, which exhibits ferroelectric properties, and a paraelectric material layer, which exhibits paraelectric properties.

As an example, the gate insulating layer GI may include one ferroelectric material layer. As another example, the gate insulating layer GI may include a plurality of ferroelectric material layers spaced apart from each other. The gate insulating layer GI may have a stacked layer structure in which a plurality of ferroelectric material layers and a plurality of paraelectric material layers are alternately stacked.

Referring to FIGS. 4 and 5A to 5D, the gate electrode GE may include a first metal pattern and a second metal pattern on the first metal pattern. The first metal pattern may be provided on the gate dielectric layer GI and may be adjacent to the first, second, and third semiconductor patterns SP1, SP2, and SP3. The first metal pattern may include a work-function metal that controls a threshold voltage of a transistor. A thickness and composition of the first metal pattern may be adjusted to achieve a desired threshold voltage of a transistor. For example, the first, second, and third portions PO1, PO2, and PO3 of the gate electrode GE may be formed of the first metal pattern or a work-function metal.

The first metal pattern may include a metal nitride layer. For example, the first metal pattern may include nitrogen (N) and at least one metal selected from the group consisting of titanium (Ti), tantalum (Ta), aluminum (Al), tungsten (W), and molybdenum (Mo). The first metal pattern may further include carbon (C). The first metal pattern may include a plurality of stacked work-function metal layers.

The second metal pattern may include metal whose resistance is less than that of the first metal pattern. For example, the second metal pattern may include at least one metal selected from the group consisting of tungsten (W), aluminum (Al), titanium (Ti), and tantalum (Ta). For example, the fourth portion PO4 of the gate electrode GE may include a first metal pattern and a second metal pattern disposed on the first metal pattern.

A first interlayer dielectric layer 110 may be provided on the substrate 100. The first interlayer dielectric layer 110 may cover the gate spacers GS and the first and second source/drain patterns SD1 and SD2. The first interlayer dielectric layer 110 may have an upper surface coplanar or substantially coplanar with an upper surface of the gate capping pattern GP and an upper surface of the gate spacer GS. A second interlayer dielectric layer 120 may be provided on the first interlayer dielectric layer 110 and may cover the gate capping pattern GP.

An etching stop layer ESL may be provided on the second interlayer insulating layer 120. The etching stop layer ESL may include an oxide. For example, the etching stop layer ESL may be a metal oxide layer.

A third interlayer insulating layer 130 may be provided on the etching stop layer ESL. A fourth interlayer insulating layer 140 may be provided on the third interlayer insulating layer 130. As an example, the first to fourth interlayer insulating layers 110, 120, 130, and 140 may include a silicon oxide layer.

The single height cell SHC may have a first boundary BD1 and a second boundary BD2 that are opposite to each other in the second direction D2. The first and second boundaries BD1 and BD2 may extend in the first direction D1. The single height cell SHC may have a third boundary BD3 and a fourth boundary BD4 that are opposite to each other in the first direction D1. The third and fourth boundaries BD3 and BD4 may extend in the second direction D2.

The single height cell SHC may be provided with a pair of separation structures DB that are on opposing sides of the single height cell SHC and are opposite to each other in the second direction D2. For example, the pair of separation structures DB may be correspondingly provided on first and second boundaries BD1 and BD2 of the single height cell SHC. The separation structure DB may extend in the first direction D1 parallel or substantially parallel to the gate electrodes GE. A pitch between the separation structure DB and its adjacent gate electrode GE may be the same as the first pitch.

The separation structure DB may penetrate the first and second interlayer dielectric layers 110 and 120 to extend into the first and second active patterns AP1 and AP2. The separation structure DB may penetrate an upper portion of each of the first and second active patterns AP1 and AP2. The separation structure DB may electrically separate an active region of the single height cell SHC from an active region of another cell that is adjacent thereto.

Active contacts AC may be provided to penetrate the first and second interlayer dielectric layers 110 and 120 and to correspondingly electrically connect the first and second source/drain patterns SD1 and SD2. A pair of active contacts AC may be provided on opposite sides of the gate electrode GE. When viewed in a plan view, the active contact AC may have a bar shape that extends in the first direction D1.

The active contact AC may be a self-aligned contact. For example, the gate capping pattern GP and the gate spacer GS may be used to form the active contact AC in a self-alignment manner. The active contact AC may cover, for example, at least a portion of a sidewall of the gate spacer GS. Although not shown, the active contact AC may cover at least a portion of the upper surface of the gate capping pattern GP.

A metal-semiconductor compound layer SC, such as a silicide layer, may be interposed between the active contact AC and the first source/drain pattern SD1 and between the active contact AC and the second source/drain pattern SD2. The active contacts AC may be electrically connected through the metal-semiconductor compound layers SC to the first and second source/drain patterns SD1 and SD2. For example, the metal-semiconductor compound layer SC may include at least one of titanium silicide, tantalum silicide, tungsten silicide, nickel silicide, and cobalt silicide.

Gate contacts GC may be provided to penetrate the second interlayer dielectric layer 120 and the gate capping pattern GP to come into electrical connection with corresponding gate electrodes GE. When viewed in a plan view, the gate contacts GC may be disposed to correspondingly overlap the first active region AR1 and the second active region AR2. For example, the gate contact GC may be provided on the second active pattern AP2 (refer to FIG. 5D).

In some example embodiments of the inventive concepts, referring to FIG. 5B, an upper dielectric pattern (not shown) may fill an upper portion of the active contact AC that is adjacent to the gate contact GC. The upper dielectric pattern may have a bottom surface lower than a bottom surface of the gate contact GC. For example, the upper dielectric pattern may cause the active contact AC adjacent to the gate contact GC to have an upper surface lower than the bottom surface of the gate contact GC. Therefore, it may be possible to limit and/or prevent an electrical short resulting from contact between the gate contact GC and the active contact AC adjacent thereto.

Each of the active contact AC and the gate contact GC may include a conductive pattern FM and a barrier pattern BM that at least partially surrounds the conductive pattern FM. For example, the conductive pattern FM may include at least one of aluminum, copper, tungsten, molybdenum, and cobalt. The barrier pattern BM may cover sidewalls and a bottom surface of the conductive pattern FM. The barrier pattern BM may include a metal layer and a metal nitride layer. The metal layer may include at least one of, for example, titanium, tantalum, tungsten, nickel, cobalt, and platinum. The metal nitride layer may include at least one of, for example, a titanium nitride (TiN) layer, a tantalum nitride (TaN) layer, a tungsten nitride (WN) layer, a nickel nitride (NiN) layer, a cobalt nitride (CoN) layer, and/or a platinum nitride (PtN) layer.

A first metal layer M1 may be provided in the third interlayer dielectric layer 130. For example, the first metal layer M1 may include a first power line M1_R1, a second power line M1_R2, and first wiring lines M1_I. Each of the lines M1_R1, M1_R2, and M1_I of the first metal layer M1 may extend parallel or substantially parallel to each other in the second direction D2.

For example, the first and second power lines M1_R1 and M1_R2 may be respectively provided on the third and fourth boundaries BD3 and BD4 of the single height cell SHC. The first power line M1_R1 may extend in the second direction D2 along the third boundary BD3. The second power line M1_R2 may extend in the second direction D2 along the fourth boundary BD4.

The first wiring lines M1_I may be disposed between the first and second power lines M1_R1 and M1_R2 of the first metal layer M1. The first wiring lines M1_I of the first metal layer M1 may be arranged at a second pitch in the first direction D1. The second pitch may be less than the first pitch. Each of the first wiring lines M1_I may have a line-width less than that of each of the first and second power lines M1_R1 and M1_R2.

The first metal layer M1 may further include first vias VI1. The first vias VI1 may be correspondingly provided below the lines M1_R1, M1_R2, and M1_I of the first metal layer M1. The first via VI1 may electrically connect the active contact AC to one of the lines M1_R1, M1_R2, and M1_I of the first metal layer M1. The first via VI1 may electrically connect the gate contact GC to one of the lines M1_R1, M1_R2, and M1_I of the first metal layer M1.

A wiring line (M1_I) and its underlying first via VI1 of the first metal layer M1 may be formed by individual processes. For example, a wiring line (M1_I) and its underlying first via VI1 of the first metal layer M1 may each be formed by a single damascene process. For example, a sub-20 nm process may be employed to fabricate a semiconductor device according to some example embodiments.

A second metal layer M2 may be provided in the fourth interlayer dielectric layer 140. The second metal layer M2 may include a plurality of second wiring lines M2_I. The second wiring lines M2_I of the second metal layer M2 may each have a linear or bar shape that extends in the first direction D1. For example, the second wiring lines M2_I may extend parallel or substantially parallel to each other in the first direction D1.

The second metal layer M2 may further include second vias VI2 correspondingly provided below the second wiring lines M2_I. A wiring line of the first metal layer M1 may be electrically connected to a corresponding wiring line of the second metal layer M2 through the second via VI2. For example, a second wiring line M2_I and its underlying second via VI2 of the second metal layer M2 may be simultaneously formed by a dual damascene process.

The first and second metal layers M1 and M2 may have wiring lines that include the same or different conductive materials from each other. For example, the first and second metal layers M1 and M2 may have wiring lines that include at least one metallic material, such as aluminum, copper, tungsten, molybdenum, ruthenium, and cobalt. Although not shown, other metal layers (e.g., M3, M4, M5, etc.) may be additionally stacked on the fourth interlayer dielectric layer 140. Each of the stacked metal layers may include wiring lines for routing between cells.

Referring to FIGS. 5C, 6A, and 6B, the etching stop layer ESL and the first via VI1 will be described in more detail. FIG. 6A is an enlarged view illustrating region 'M' of FIG. 5C. FIG. 6B is an enlarged view illustrating region 'N of FIG. 6A.

Referring to FIG. 6A, the first via VI1 may connect the lines M1_R1, M1_R2, and M1_I of the first metal layer M1 and the conductive patterns FM. The conductive patterns may include a conductive material. For example, the conductive patterns may be any one of the conductive pattern FM of the active contact AC, the conductive pattern FM of the gate contact GC, and the lines of the first and second metal layers M1 and M2 of the gate electrode GE. The first via VI1 of FIG. 6A may vertically connect the first power line M1_R1 and the active contact AC.

The first via VI1 may include a via conductive pattern VFM and a via barrier pattern VBM surrounding the via conductive pattern VFM. The via barrier pattern VBM includes a first barrier pattern VBM1 and a second barrier pattern VBM2 on the first barrier pattern VBM1. The via conductive pattern VFM may include at least one metal of aluminum, copper, tungsten, molybdenum, and cobalt.

The first barrier pattern VBM1 may cover sidewalls of the via conductive pattern VFM. The first barrier pattern VBM1 need not be provided at a lower portion of the first via VI1. For example, the first barrier pattern VBM1 need not be provided between the first via VI1 and the etching stop layer ESL. The first barrier pattern VBM1 and the conductive pattern FM may be spaced apart from each other with the etching stop layer ESL therebetween. The second barrier pattern VBM2 may cover sidewalls and a bottom surface of the via conductive pattern VFM. The second barrier pattern VBM2 may extend between the bottom surface of the via conductive pattern VFM and the upper surface of the conductive pattern FM. Accordingly, only the second barrier pattern VBM2 may be provided at a lower portion of the first via VI1. The lowest level of the second barrier pattern VBM2 may be lower than the lowest level of the first barrier pattern VBM1.

The first barrier pattern VBM1 may include a transition metal. The first barrier pattern VBM1 may include a plurality of metal layers/metal nitride layers. The metal layers may include at least one of titanium, tantalum, tungsten, nickel, cobalt, and platinum. The metal nitride layer may include at least one of a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer.

As an example, the first barrier pattern VBM1 may include tantalum nitride (TaN) layers and ruthenium (Ru) layers that are alternately stacked. The first barrier pattern VBM1 may be a tantalum nitride (TaN) layer-ruthenium (Ru) layer-tantalum nitride (TaN) layer-ruthenium (Ru) layer. The first barrier pattern VBM1 may include ruthenium (Ru), but the second barrier pattern VBM2 may not include ruthenium (Ru). Accordingly, the second barrier pattern VBM2 may react with a conductive material (e.g., copper) of the conductive pattern FM of the active contact AC to limit and/or prevent corrosion of the conductive pattern FM. When corrosion of the conductive pattern FM occurs, a void may be formed on an upper portion of the conductive pattern FM, which may significantly deteriorate electrical characteristics.

The second barrier pattern VBM2 may include a different transition metal from that of the first barrier pattern VBM1. The second barrier pattern VBM2 may include at least one of titanium, tantalum, tungsten, nickel, cobalt, platinum, and a combination thereof. Preferably, the second barrier pattern VBM2 may include cobalt. As another example, the second barrier pattern VBM2 may also include a metal layer/metal nitride layer.

The barrier pattern BM of the active contact AC may include a first active barrier pattern BM1a and a second active barrier pattern BM1b. The second active barrier pattern BM1b may be provided on the first active barrier pattern BM1a. The first active barrier pattern BM1a may include a metal layer, a metal nitride layer, or a combination thereof. Unlike the first barrier pattern VBM1, the first active barrier pattern BM1a may be a tantalum nitride (TaN) layer-ruthenium (Ru) layer-tantalum nitride (TaN) layer. As another example, the first active barrier pattern BM1a may be the same or substantially the same as the first barrier pattern VBM1. The second active barrier pattern BM1b may include a metal layer, a metal nitride layer, or a combination thereof. The second active barrier pattern BM1b may include cobalt-ruthenium (Co-Ru).

The etching stop layer ESL may include oxygen. The etching stop layer ESL may include a metal oxide. As an example, the etching stop layer ESL may include aluminum oxide (AlOx).

A side barrier pattern SBP may be provided in a lower portion of the first via VI1. The side barrier pattern SBP is interposed between the second barrier pattern VBM2 and the etching stop layer ESL. As another example, the side barrier pattern SBP may extend from the sidewall of the second barrier pattern VBM2 to a bottom surface of the second barrier pattern VBM2.

The side barrier pattern SBP includes a transition metal oxide. The side barrier pattern SBP may be an oxide including manganese (Mn), titanium (Ti), hafnium (Hf), chromium (Cr), niobium (Nb), tantalum (Ta), and vanadium (V). The side barrier pattern SBP may include a different transition metal from that of the first and second barrier patterns VBM1 and VBM2. For example, the first barrier pattern VBM1 may include a ruthenium layer and a tantalum nitride layer, the second barrier pattern VBM2 may include cobalt (Co), and the side barrier pattern SBP may include manganese oxide. In a manufacturing method described below, the side barrier pattern SBP may be formed by a reaction between a transition metal and oxygen of an etching stop layer ESL. For example, the side barrier pattern SBP may be a material formed by a reaction between a transition metal and oxygen of the etching stop layer ESL.

Referring to FIG. 6B, the lower portion of the first via VI1 may include a protrusion PTP protruding toward the etching stop layer ESL. For example, the lower portion of the first via VI1 may include a protrusion PTP protruding laterally toward the etching stop layer ESL. Due to the protrusion PTP, a width of a lower portion of the first via VI1 may be greater than a width of an upper portion of the first via VI1. The side barrier pattern SBP may be interposed between the protrusion PTP and the etching stop layer ESL. The first barrier pattern VBM1 may not be provided on the protrusion PTP. The second barrier pattern VBM2 may cover a sidewall and a bottom surface of the protrusion PTP.

The graph of FIG. 6B is a graph illustrating a concentration of a transition metal (e.g., manganese) in an X direction. A concentration of manganese in the via conductive pattern VFM may increase in the X direction. The second barrier pattern VBM2 may have a first manganese concentration C1. The first manganese concentration C1 may be defined as a concentration of manganese (Mn) contained in the second barrier pattern VBM2. The first manganese concentration C1 may be greater than a concentration of manganese in the via conductive pattern VFM. The first manganese concentration C1 may increase in the X direction.

The side barrier pattern SBP may have a second manganese concentration C2. The second manganese concentration C2 may be the maximum value of the concentration of manganese (Mn) contained in the side barrier pattern SBP. The side barrier pattern SBP may have a manganese concentration greater than that of each of the etching stop layer ESL, the second barrier pattern VBM2, and the via conductive pattern VFM. The manganese concentration of the etching stop layer ESL may decrease in the X direction and may converge to 0. A unit of the first and second manganese concentrations C1 and C2 may be atom/cm³.

For example, the concentration of manganese may increase as the protrusion PTP of the first via VI1 gets closer to the etching stop layer ESL. For example, the concentration of the manganese in the protrusion PTP may increase along the lateral direction X approaching toward the etching stop layer ESL. The concentration of manganese may increase as the protrusion PTP gets closer from the first via VI1 to the etching stop layer ESL and may have a maximum value at an interface between the first via VI1 and the etching stop layer ESL. Thereafter, the concentration of manganese may decrease again from the interface to the etching stop layer ESL.

Referring again to FIG. 6A, the first wiring line M1_I may include a trench barrier pattern TBM. The trench barrier pattern TBM may be the same or substantially the same as the via barrier pattern VBM. The trench barrier pattern TBM may include a first trench barrier pattern TBM1 and a second trench barrier pattern TBM2 on the first trench barrier pattern TBM1. The first trench barrier pattern TBM1 may be identical or substantially identical to the first barrier pattern VBM1, and the second trench barrier pattern TBM2 may be identical or substantially identical to the second barrier pattern VBM2. However, unlike the first barrier pattern VBM1, the first trench barrier pattern TBM1 may cover the bottom surface of the conductive pattern of the first wiring line M1_I.

A lower barrier pattern TBP may be formed below the first wiring line M1_I. The lower barrier pattern TBP may be identical or substantially identical to the side barrier pattern SBP. However, the lower barrier pattern TBP may have a lower manganese concentration than that of the side barrier pattern SBP. This is because the lower barrier pattern TBP is separated from the etching stop layer ESL containing a lot of oxygen. The lower barrier pattern TBP may be interposed between the first trench barrier pattern TBM1 and the second trench barrier pattern TBM2.

The description of the first via VI1 according to the inventive concepts may also be applied to the gate contact GC, the active contact AC, and the first and second wiring lines M1_I and M2_1. For example, the description of the via barrier pattern VBM may also be equally or substantially equally applied to the barrier pattern BM of the gate contact GC, the barrier pattern BM of the active contact AC, and the first and second wiring lines M1_I and M2_1.

According to the inventive concepts, a side barrier pattern SBP may be interposed between the protrusion PTP of the first via VI1 and the etching stop layer ESL. The side barrier pattern SBP includes a transition metal oxide, which may limit and/or prevent a conductive material of the first via VI1 from diffusing. The first barrier pattern VBM1 may include ruthenium (Ru), and the second barrier pattern VBM2 need not include ruthenium (Ru). As a result, corrosion of the conductive pattern FM caused by contact between ruthenium (Ru) and the conductive pattern FM may be limited and/or prevented, thereby limiting and/or preventing voids in the conductive pattern FM. As a result, reliability and electrical characteristics of the semiconductor device may be improved.

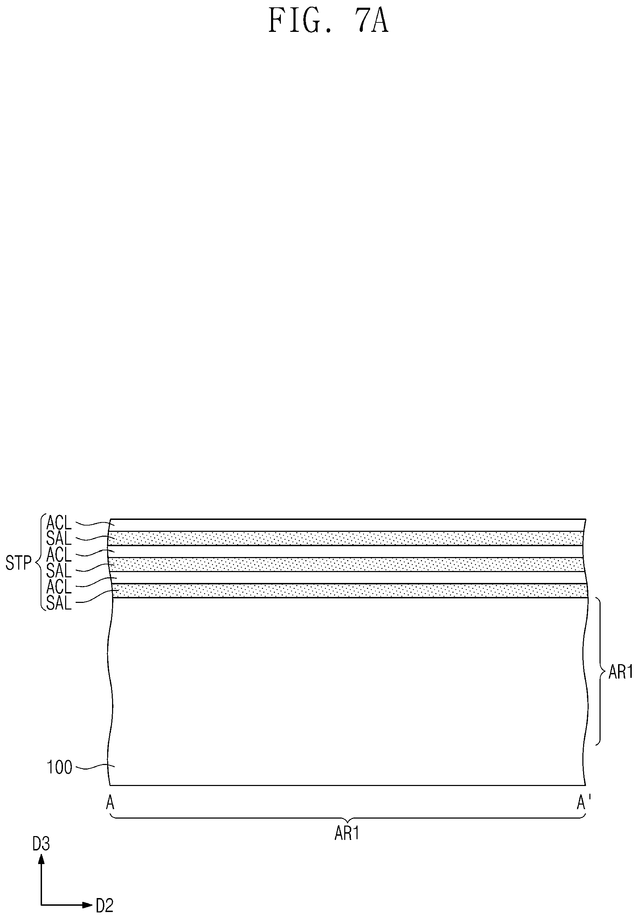

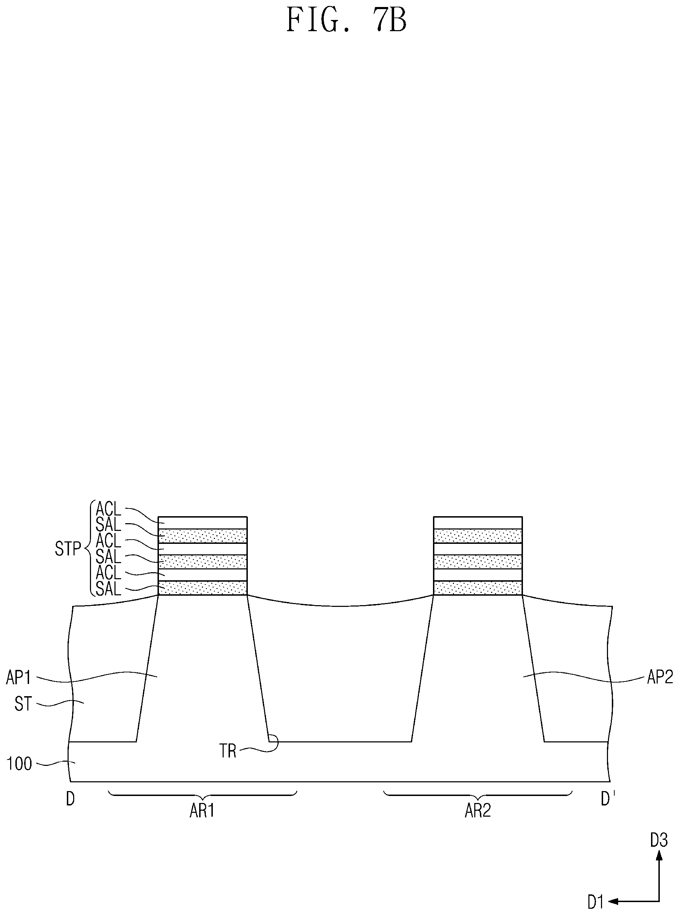

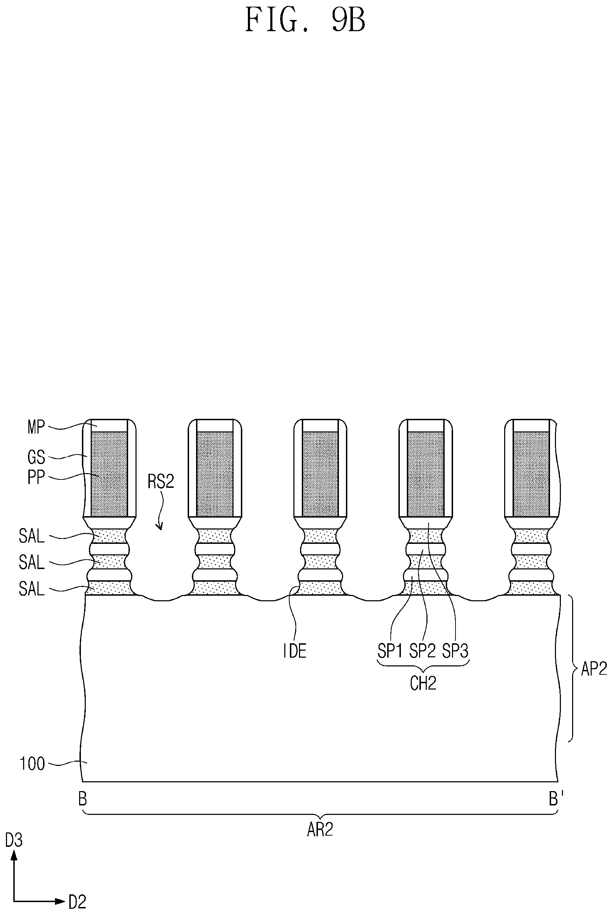

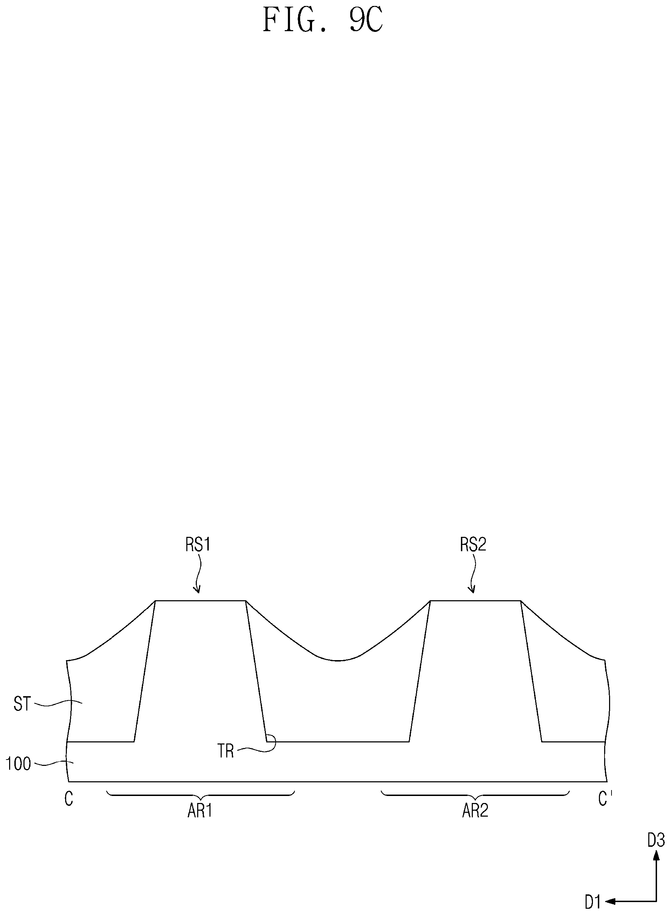

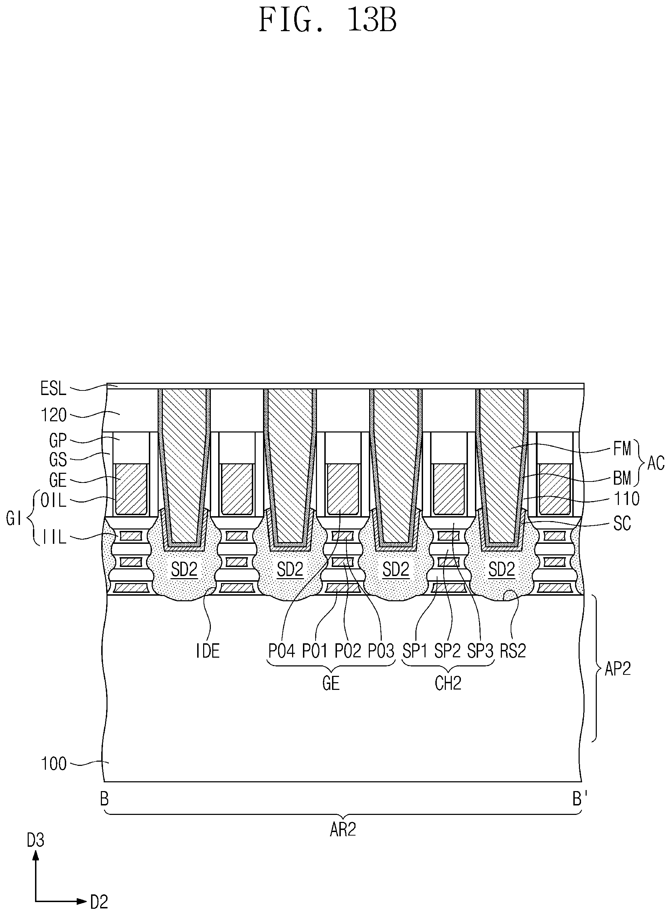

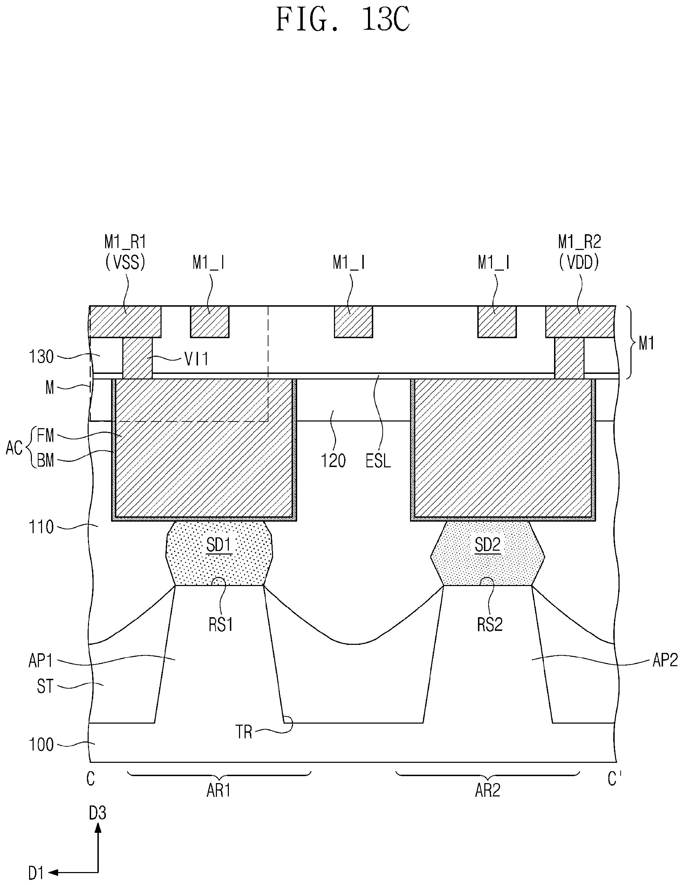

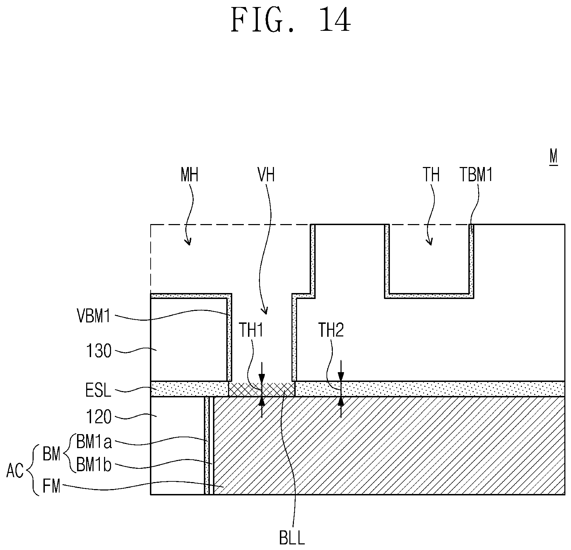

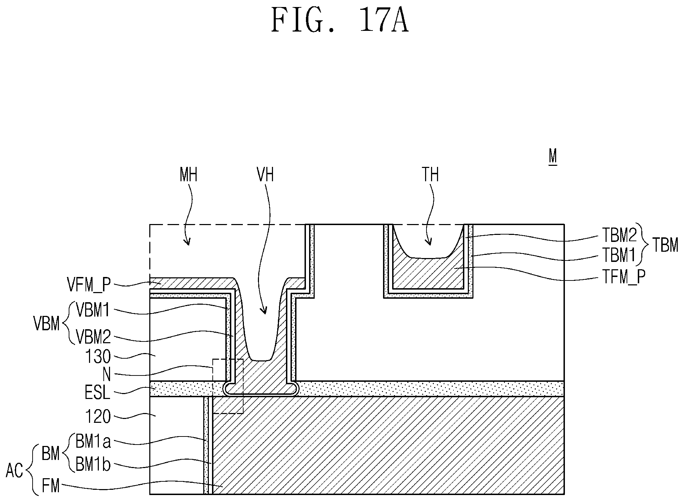

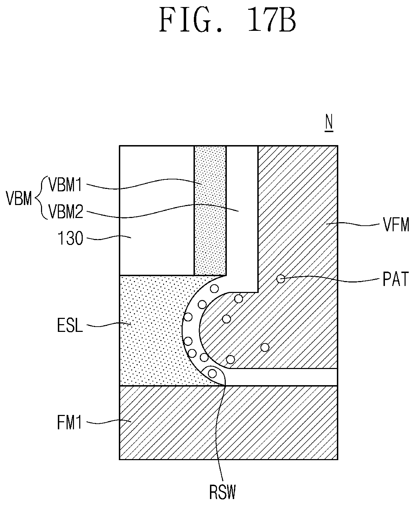

FIGS. 7A to 18 are drawings for illustrating a method of manufacturing a semiconductor device according to some example embodiments of the inventive concepts. For example, FIGS. 7A, 8A, 9A, 10A, 11A, 12A, and 13A are cross-sectional views corresponding to line A-A' of FIG. 4. FIGS. 9B, 10B, 11B, 12B, and 13B are cross-sectional views corresponding to line B-B' of FIG. 4. FIGS. 9C, 10C, 11C, 12C, and 13C are cross-sectional views corresponding to the C-C' line of FIG. 4. FIGS. 7B, 8B, 11D, and 12D are cross-sectional views corresponding to the D-D' line of FIG. 4. FIGS. 14, 15, 16, and 17A are enlarged views for illustrating a method of forming region 'M' of FIG. 13C. FIG. 17B is an enlarged view illustrating region 'N' of FIG. 17A.

Referring to FIGS. 7A and 7B, a substrate 100 including first and second active regions AR1 and AR2 may be provided. Active layers ACL and sacrificial layers SAL may be formed alternately on the substrate 100. The active layers ACL may include one of silicon (Si), germanium (Ge), and silicon-germanium (SiGe), and the sacrificial layers SAL may include another of silicon (Si), germanium (Ge), and silicon-germanium (SiGe).

The sacrificial layer SAL may include a material that has an etching selectivity with respect to the active layer ACL. For example, the active layers ACL may include silicon (Si), and the sacrificial layers SAL may include silicon-germanium (SiGe). A concentration of germanium (Ge) in each of the sacrificial layers SAL may be 10 at% to 30 at%.

Mask patterns may be formed on the first and second active regions AR1 and AR2 of the substrate 100, respectively. The mask pattern may have a line shape or a bar shape extending in a second direction D2.

A patterning process may be performed using the mask patterns as an etching mask to form a trench TR defining a first active pattern AP1 and a second active pattern AP2. The first active pattern AP1 may be formed on the first active region AR1. The second active pattern AP2 may be formed on the second active region AR2.

A stacked pattern STP may be formed on each of the first and second active patterns AP1 and AP2. The stacked pattern STP may include active layers ACL and sacrificial layers SAL alternately stacked on each other. The stacked pattern STP may be formed together with the first and second active patterns AP1 and AP2 during the patterning process.

A device isolation layer ST filling the trench TR may be formed. For example, an insulating layer covering the first and second active patterns AP1 and AP2 and the stacked patterns STP may be formed on the entire surface of the substrate 100. The insulating layer may be recessed until the stacked patterns STP are exposed, and thus the device isolation layer ST may be formed.

The device isolation layer ST may include an insulating material, such as a silicon oxide layer. The stacked patterns STP may be exposed over the device isolation layer ST. For example, the stacked patterns STP may protrude vertically from the device isolation layer ST.

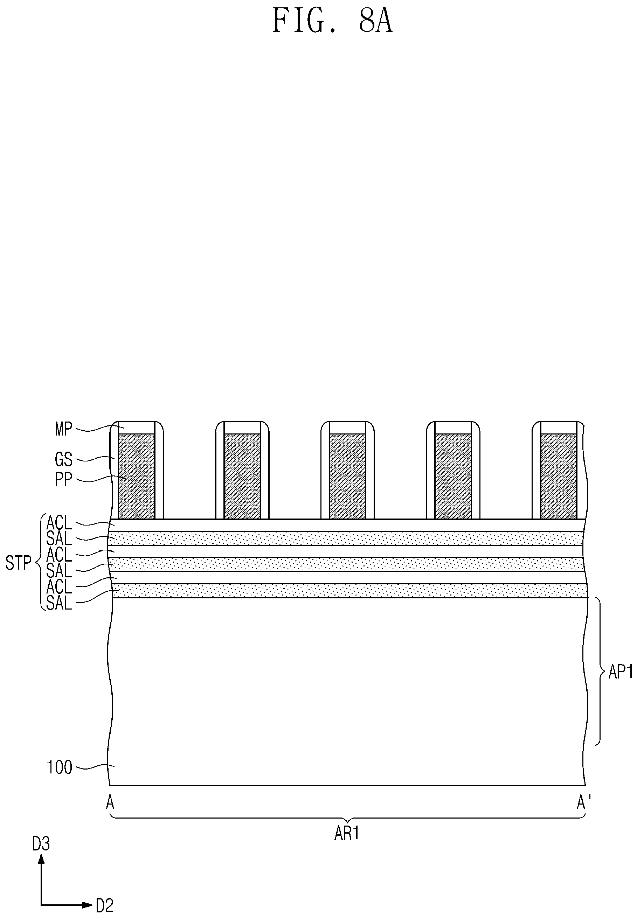

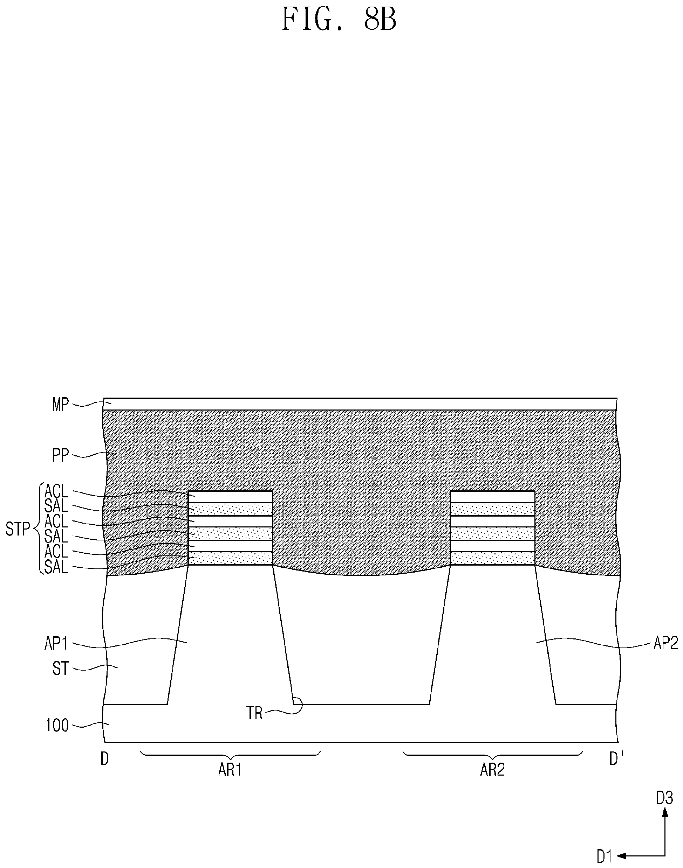

Referring to FIGS. 8A and 8B, sacrificial patterns PP crossing the stacked patterns STP may be formed on the substrate 100. Each of the sacrificial patterns PP may be formed in a line shape or a bar shape extending in a first direction D1. The sacrificial patterns PP may be arranged in the second direction D2 with a first pitch.

For example, forming the sacrificial patterns PP may include forming a sacrificial layer on the entire surface of the substrate 100, forming hard mask patterns MP on the sacrificial layer, and patterning the sacrificial layer using the hard mask patterns MP as an etching mask. The sacrificial layer may include polysilicon.

A pair of gate spacers GS may be formed on both sidewalls of each of the sacrificial patterns PP. Forming the gate spacers GS may include conformally forming a gate spacer layer on the entire surface of the substrate 100, and anisotropically etching the gate spacer layer. In some example embodiments of the inventive concepts, the gate spacer GS may be a multi-layer including at least two layers.

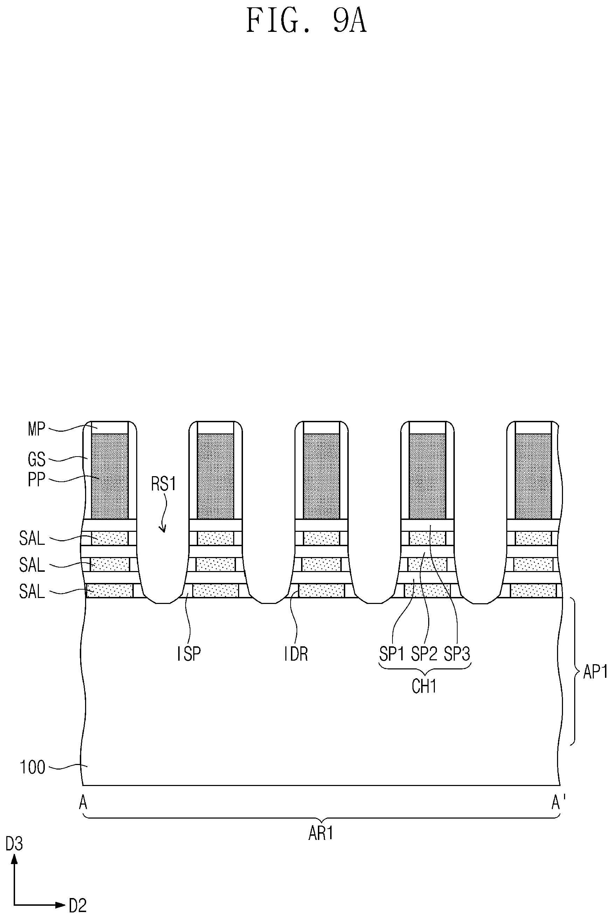

Referring to FIGS. 9A to 9C, first recesses RS1 may be formed in the stacked pattern STP on the first active pattern AP1. Second recesses RS2 may be formed in the stacked pattern STP on the second active pattern AP2. While forming the first and second recesses RS1 and RS2, the device isolation layer ST on both sides of each of the first and second active patterns AP1 and AP2 may be further recessed (refer to FIG. 9C).

For example, the stacked pattern STP on the first active pattern AP1 may be etched using the hard mask patterns MP and gate spacers GS as an etching mask to form the first recesses RS1. The first recesses RS1 may be formed between a pair of sacrificial patterns PP.

From the active layers ACL, first to third semiconductor patterns SP1, SP2, and SP3 sequentially stacked between adjacent first recesses RS1 may be formed, respectively. The first to third semiconductor patterns SP1, SP2, and SP3 between adjacent first recesses RS1 may form a first channel pattern CH1.

The first recess RS1 may be formed between adjacent sacrificial patterns PP. A width of the first recess RS1 in the second direction D2 may become smaller as the first recess RS1 approaches the substrate 100.

The sacrificial layers SAL may be exposed by the first recess RS1. A selective etching process may be performed on the exposed sacrificial layers SAL. The etching process may include a wet etching process that selectively removes only silicon-germanium. By the etching process, each of the sacrificial layers SAL may be indented, and thus an indent region IDR may be formed. A sidewall of the sacrificial layer SAL may be concave due to the indent region IDR. An insulating layer may be formed in the first recess RS1 to fill the indent regions IDR. The first to third semiconductor patterns SP1, SP2, and SP3 and the sacrificial layers SAL exposed by the first recess RS1 may become a seed layer of the insulating layer. The insulating layer may be grown as a crystalline dielectric layer on the crystalline semiconductor forming the first to third semiconductor patterns SP1, SP2, and SP3 and the sacrificial layers SAL.

An inner spacer ISP may be formed to fill the indent region IDR. For example, forming the inner spacer ISP may include wet-etching the epitaxial dielectric layer until the sidewalls of the first to third semiconductor patterns SP1, SP2, and SP3 are exposed. As a result, the epitaxial dielectric layer may remain only in the indent region IDR to constitute the inner spacer ISP.

The second recesses RS2 in the stacked pattern STP on the second active pattern AP2 may be formed in a similar manner to forming the first recesses RS1. A selective etching process may be performed on the sacrificial layers SAL exposed by the second recesses RS2, so that indent regions IDE may also be formed on the second active pattern AP2. The second recesses RS2 may have wavy inner sidewalls due to the indent regions IDE. In the indent regions IDE on the second active pattern AP2, inner spacers ISP may not be formed. The first to third semiconductor patterns SP1, SP2, and SP3 between the adjacent second recesses RS2 may constitute a second channel pattern CH2.

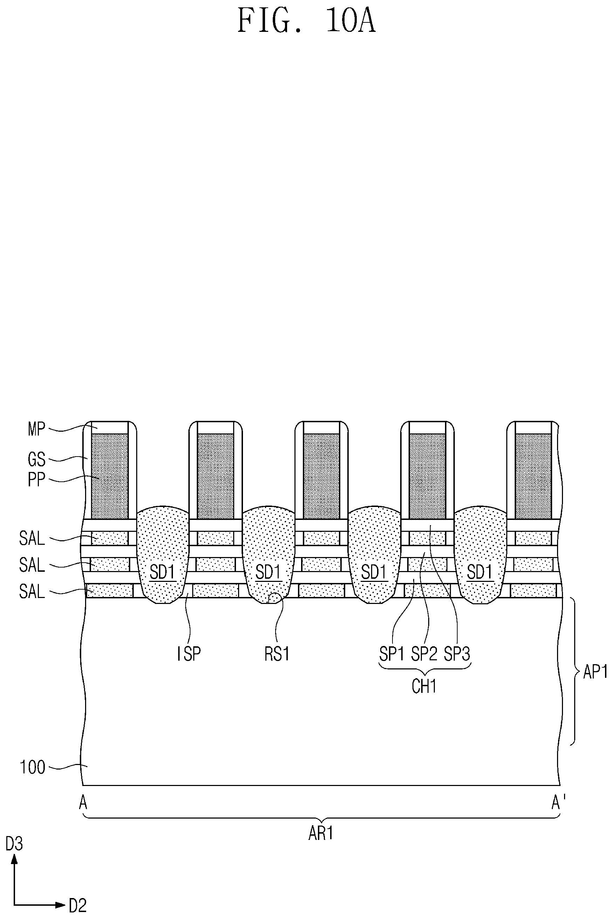

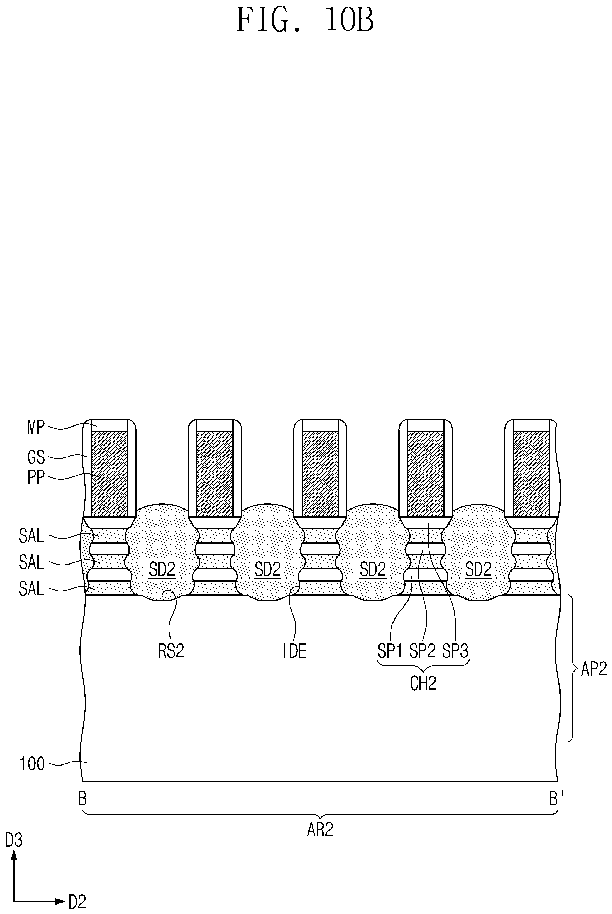

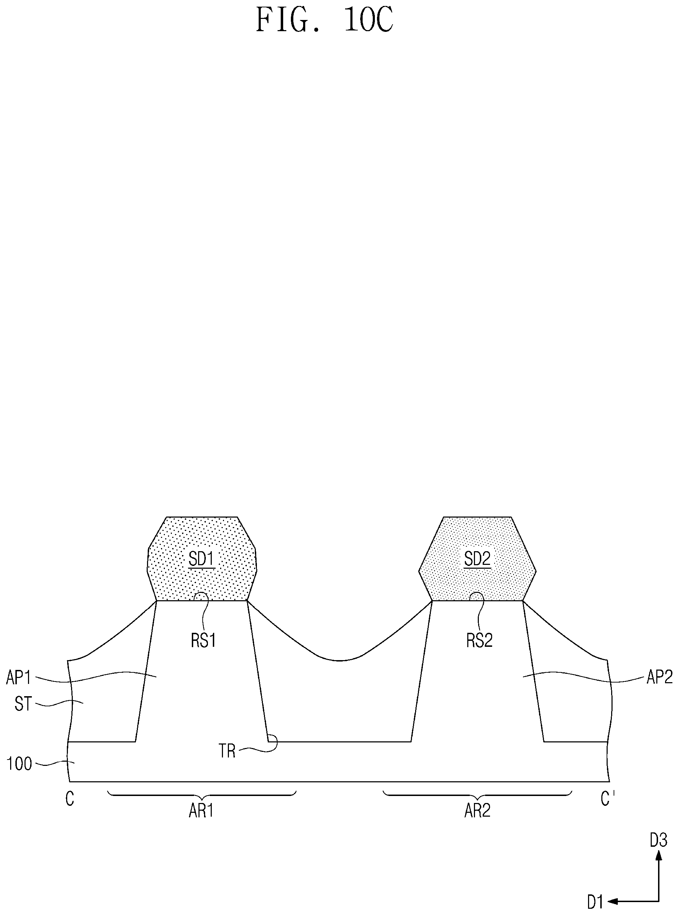

Referring to FIGS. 10A to 10C, first source/drain patterns SD1 may be formed in each of the first recesses RS1. For example, an SEG (selective epitaxial growth) process may be performed using the inner wall of the first recess RS1 as a seed layer to form an epitaxial layer filling the first recess RS1. The epitaxial layer may be grown using the first to third semiconductor patterns SP1, SP2, and SP3 exposed by the first recess RS1 and the substrate 100 as a seed. For example, the SEG process may include a chemical vapor deposition (CVD) process or a molecular beam epitaxy (MBE) process.

In some example embodiments of the inventive concepts, the first source/drain pattern SD1 may include the same semiconductor element (e.g., Si) as the substrate 100. While the first source/drain pattern SD1 is formed, an impurity (e.g., phosphorus, arsenic, or antimony) that causes the first source/drain pattern SD1 to have an n-type may be implanted in-situ. As another example, an impurity may be implanted into the first source/drain pattern SD1 after the first source/drain pattern SD1 is formed.

Second source/drain patterns SD2 may be formed respectively in the second recesses RS2. For example, the second source/drain pattern SD2 may be formed by performing an SEG process using the inner wall of the second recess RS2 as a seed layer.

In some example embodiments of the inventive concepts, the second source/drain pattern SD2 may include a semiconductor element (e.g., SiGe) having a lattice constant greater than a lattice constant of a semiconductor element of the substrate 100. While the second source/drain pattern SD2 is formed, an impurity (e.g., boron, gallium, or indium) that causes the second source/drain pattern SD2 to have a p-type may be implanted in-situ. As another example, an impurity may be implanted into the second source/drain pattern SD2 after the second source/drain pattern SD2 is formed.

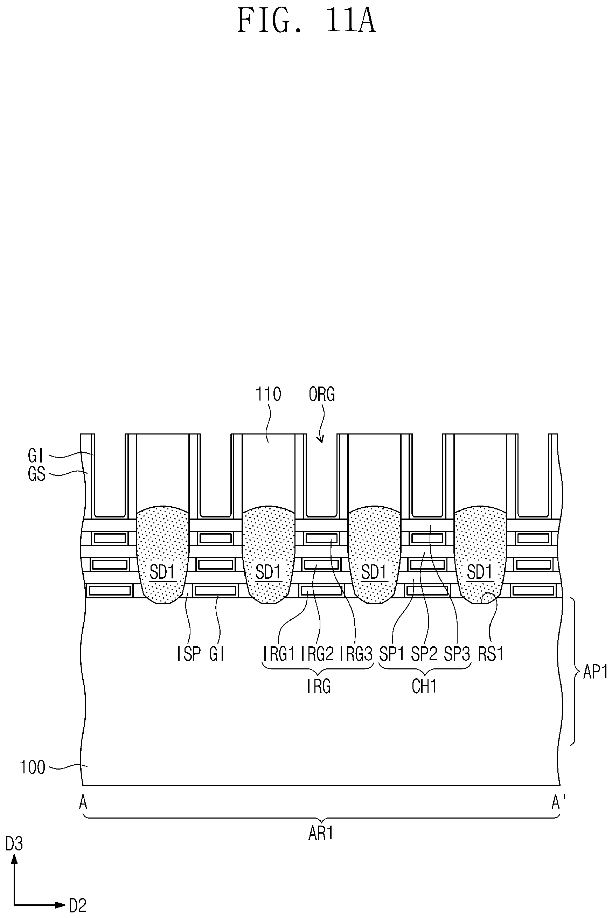

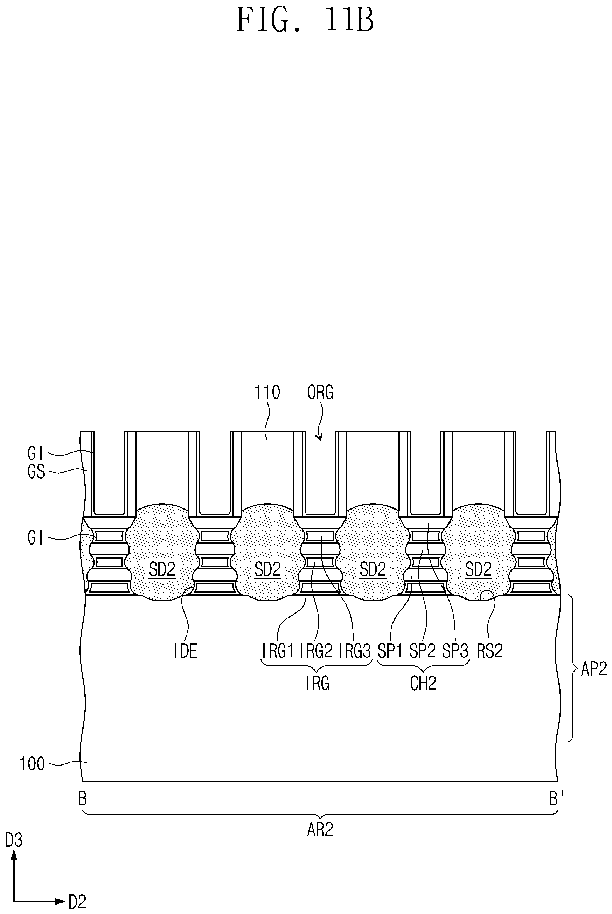

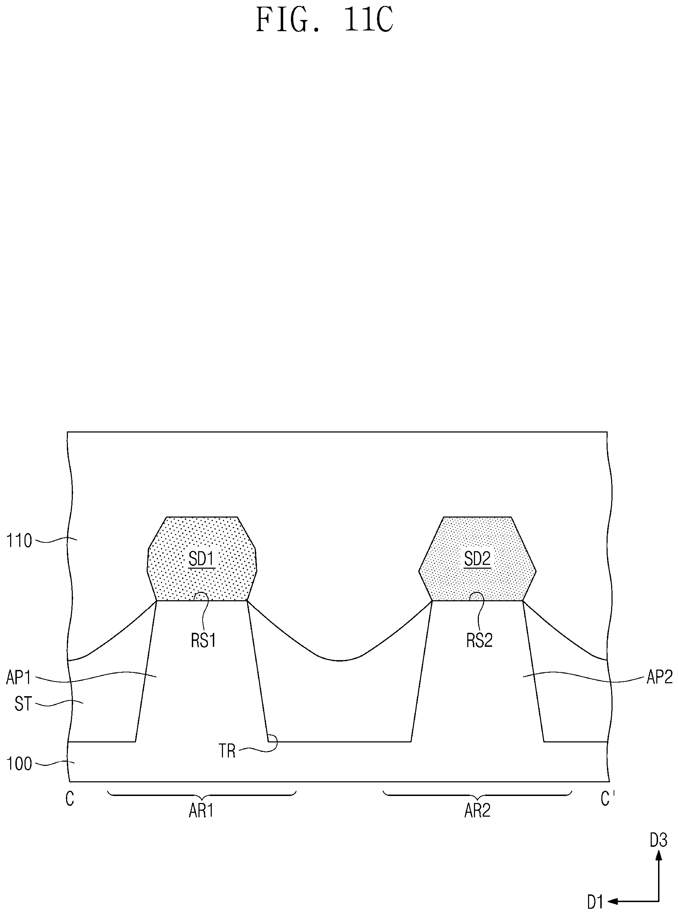

Referring to FIGS. 11A to 11D, a first interlayer insulating layer 110 covering the first and second source/drain patterns SD1 and SD2, the hard mask patterns MP, and the gate spacers GS may be formed. For example, the first interlayer insulating layer 110 may include a silicon oxide layer.

The first interlayer insulating layer 110 may be planarized until upper surfaces of the sacrificial patterns PP are exposed. The planarization of the first interlayer insulating layer 110 may be performed using an etch back or chemical mechanical polishing (CMP) process. During the planarization process, the hard mask patterns MP may be completely removed. As a result, an upper surface of the first interlayer insulating layer 110 may be coplanar with the upper surfaces of the sacrificial patterns PP and upper surfaces of the gate spacers GS.

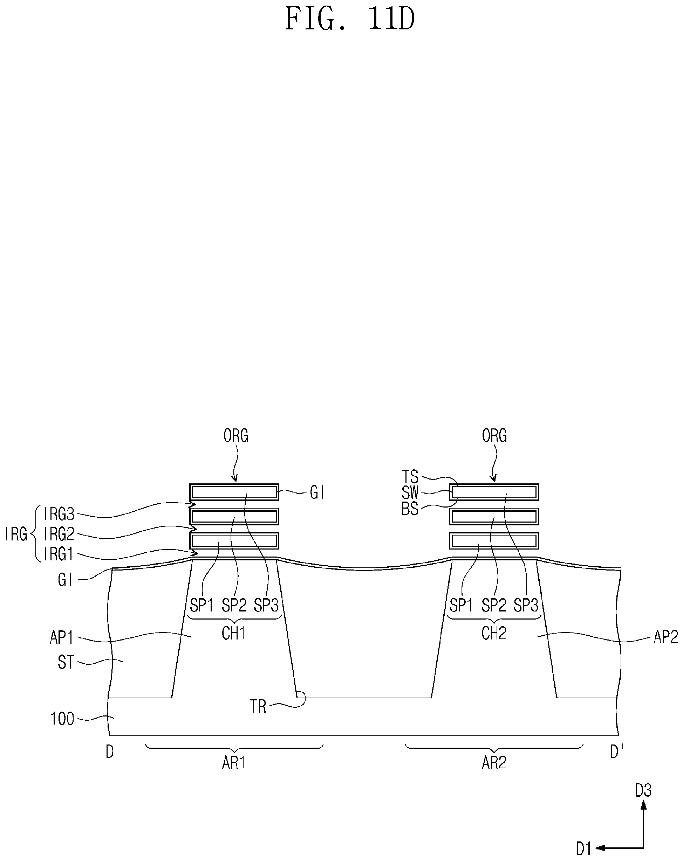

The exposed sacrificial patterns PP may be selectively removed. By removing the sacrificial patterns PP, an outer region ORG exposing the first and second channel patterns CH1 and CH2 may be formed (refer to FIG. 11D). Removing the sacrificial patterns PP may include wet etching using an etchant that selectively etches polysilicon.

The sacrificial layers SAL exposed through the outer region ORG may be selectively removed to form inner regions IRG (refer to FIG. 11D). For example, by performing an etching process that selectively etches the sacrificial layers SAL, only the sacrificial layers SAL may be removed while leaving the first to third semiconductor patterns SP1, SP2, and SP3 intact. The etching process may have a high etching rate for silicon-germanium having a relatively high germanium concentration. For example, the etching process may have a high etching rate for silicon-germanium having a germanium concentration greater than 10 at%.

During the etching process, the sacrificial layers SAL on the first and second active regions AR1 and AR2 may be removed. The etching process may be wet etching. The etching material used in the etching process may quickly remove the sacrificial layer SAL having a relatively high germanium concentration.

Referring to FIG. 11D again, as the sacrificial layers SAL are selectively removed, only the first to third semiconductor patterns SP1, SP2, and SP3 stacked on each of the first and second active patterns AP1 and AP2 may remain. First to third inner regions IRG1, IRG2 and IRG3 may be formed through the regions where the sacrificial layers SAL are removed, respectively.

For example, a first inner region IRG1 may be formed between the active pattern AP1 or AP2 and the first semiconductor pattern SP1, a second inner region IRG2 may be formed between the first semiconductor pattern SP1 and the second semiconductor pattern SP2, and a third inner region IRG3 may be formed between the second semiconductor pattern SP2 and the third semiconductor pattern SP3.

Referring again to FIGS. 11A to 11D, a gate insulating layer GI may be formed on the exposed first to third semiconductor patterns SP1, SP2, and SP3. The gate insulating layer GI may be formed to surround each of the first to third semiconductor patterns SP1, SP2, and SP3. The gate insulating layer GI may be formed in each of the first to third inner regions IRG1, IRG2 and IRG3. The gate insulating layer GI may be formed in the outer region ORG.

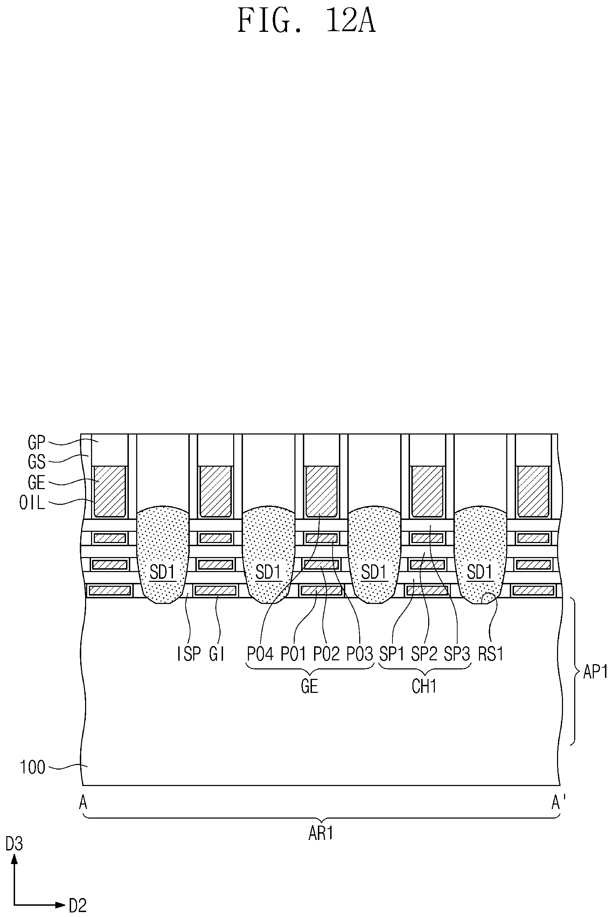

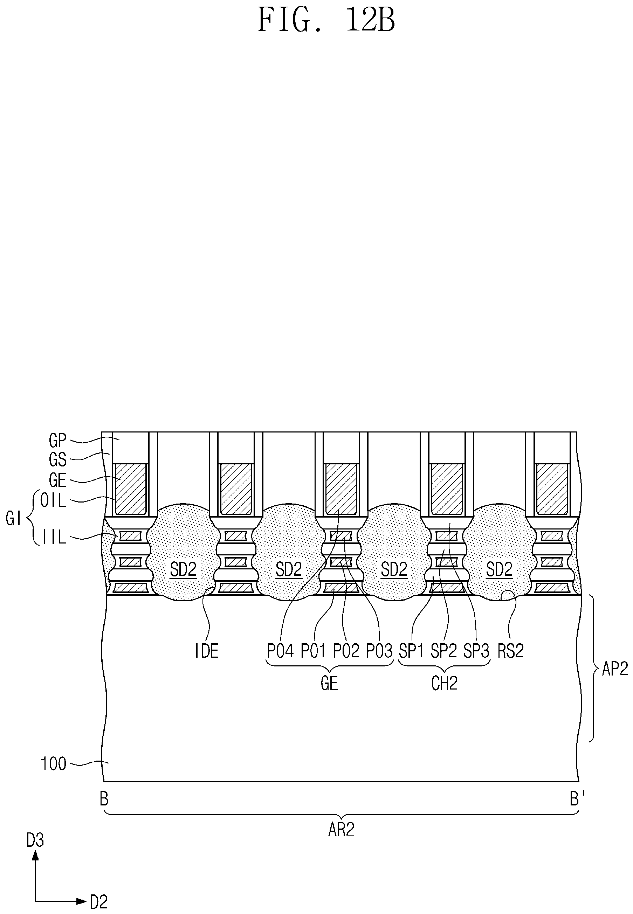

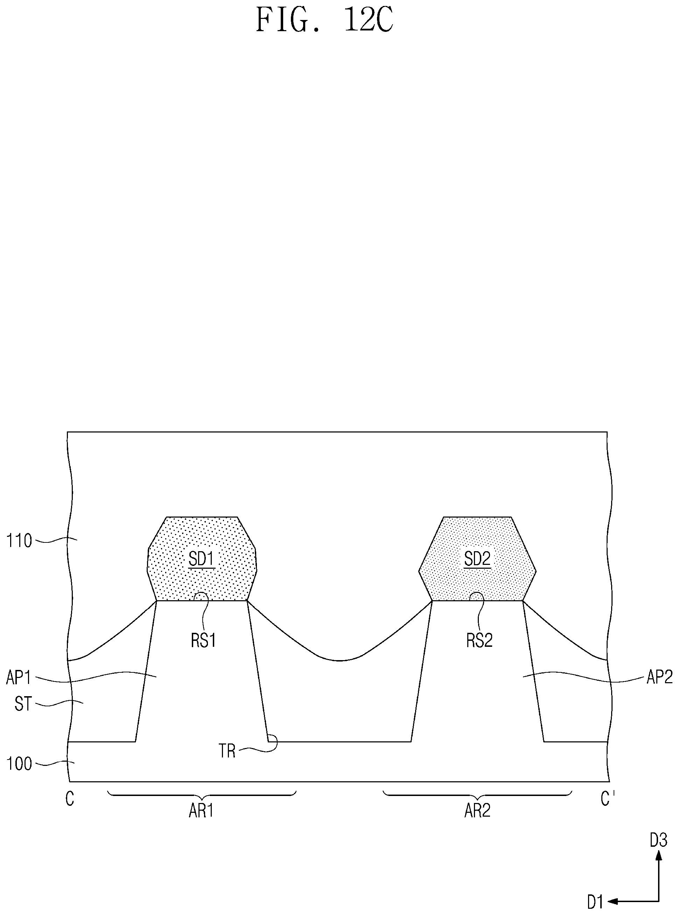

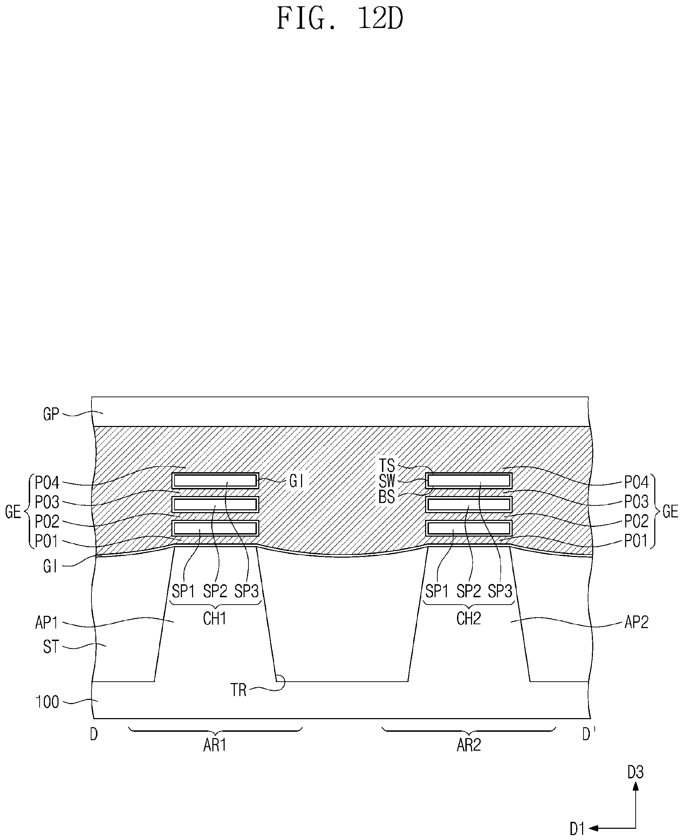

Referring to FIGS. 12A to 12D, a gate electrode GE may be formed on the gate insulating layer GI. The gate electrode GE may include first to third inner electrodes PO1, PO2, and PO3 formed in the first to third inner regions IRG1, IRG2 and IRG3, respectively, and an outer electrode PO4 formed in the outer region ORG. The gate electrode GE may be recessed, so that a height thereof may be reduced. A gate capping pattern GP may be formed on the recessed gate electrode GE.

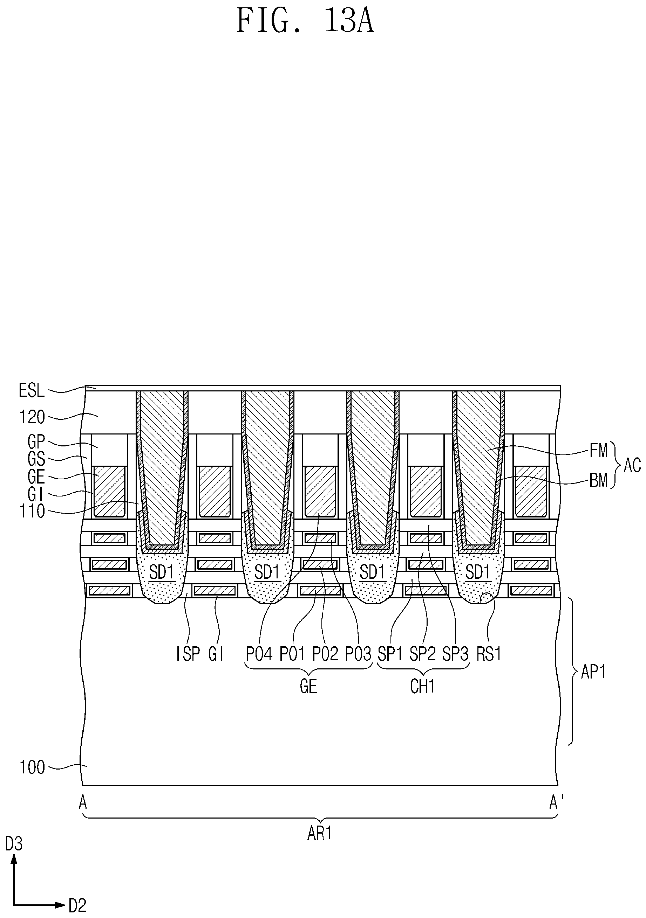

Referring to FIGS. 13A to 13C and FIGS. 5A to 5D, a second interlayer insulating layer 120 may be formed on the first interlayer insulating layer 110. The second interlayer insulating layer 120 may include a silicon oxide layer. Active contacts AC may be formed that are electrically connected to the first and second source/drain patterns SD1 and SD2 by penetrating the second interlayer insulating layer 120 and the first interlayer insulating layer 110. Gate contacts GC that are electrically connected to the gate electrode GE by penetrating the second interlayer insulating layer 120 and the gate capping pattern GP may be formed.

Forming each of the active contacts AC and the gate contact GC may include forming a barrier pattern BM and forming a conductive pattern FM on the barrier pattern BM. The barrier pattern BM may be formed conformally and may include a metal layer/metal nitride layer. The conductive pattern FM may include a low-resistance metal.

Separation structures DB may be formed at each of a first boundary BD1 and a second boundary BD2 of the single height cell SHC (e.g., see FIG. 5A). The separation structure DB may extend from the second interlayer insulating layer 120 through the gate electrode GE into an interior of the active pattern AP1 or AP2. The separation structure DB may include an insulating material such as a silicon oxide layer or a silicon nitride layer.

Referring to FIGS. 13A to 13C and FIGS. 5A to 5D, an etching stop layer ESL may be formed on the active contacts AC and the gate contacts GC. A third interlayer insulating layer 130 may be formed on the etching stop layer ESL. A first metal layer M1 may be formed in the third interlayer insulating layer 130.

Referring again to FIGS. 5A to 5D, a fourth interlayer insulating layer 140 may be formed on the third interlayer insulating layer 130. A second metal layer M2 may be formed in the fourth interlayer insulating layer 140.

Referring to FIGS. 14 to 18, a method of forming region 'M' of FIG. 13C will be described.

Referring to FIG. 14, the third interlayer insulating layer 130 may be etched to form a wiring hole MH, a via hole VH, and a trench hole TH. The wiring hole MH, the via hole VH, and the trench hole TH may be filled with a conductive material later to become a first power line M1_R1, a first via VI1, and a first wiring line M1_I, respectively. The wiring hole MH, the via hole VH, and the trench hole TH may be formed by a single damascene process or a dual damascene process, but are not limited thereto.

A portion of the etching stop layer ESL may be exposed by the via hole VH. The exposed etching stop layer ESL may be removed, and a blocking layer BLL may be formed. The blocking layer BLL may be an oxide layer or a nitride layer deposited by performing a chemical vapor deposition (CVD) process. A thickness TH1 of the blocking layer BLL may be equal to or smaller than a thickness TH2 of the etching stop layer ESL. The blocking layer BLL may include a silicon oxide layer or a silicon nitride layer. For example, the blocking layer BLL may include a material having etch selectivity for ruthenium (Ru).

A first barrier pattern VBM1 may be conformally formed on an inner wall of each of the wiring hole MH, the via hole VH, and the trench hole TH. For example, the first barrier pattern VBM1 may be formed by alternately depositing a plurality of metal layers and metal nitride layers. For example, forming the first barrier pattern VBM1 may include: forming a first tantalum nitride (TaN) layer on the inner wall, forming a first ruthenium (Ru) layer on the first tantalum nitride (TaN) layer, forming a second tantalum nitride (TaN) layer on the first ruthenium (Ru) layer, and forming a second ruthenium (Ru) layer on the second tantalum nitride (TaN) layer. Forming the first and second tantalum nitride (TaN) layers may be performed by a mechanism similar to an atomic layer deposition (ALD) process. Forming the first and second ruthenium (Ru) layers may be performed by a chemical vapor deposition (CVD) process.

The first barrier pattern VBM1 need not be formed on an upper surface of the blocking layer BLL. Accordingly, the upper surface of the blocking layer BLL may still be exposed by the via hole VH. Due to the blocking layer BLL, the first barrier pattern VBM1 may be spaced apart from the conductive pattern FM. The first barrier pattern VBM1 need not be formed in a lower portion of the via hole VH.

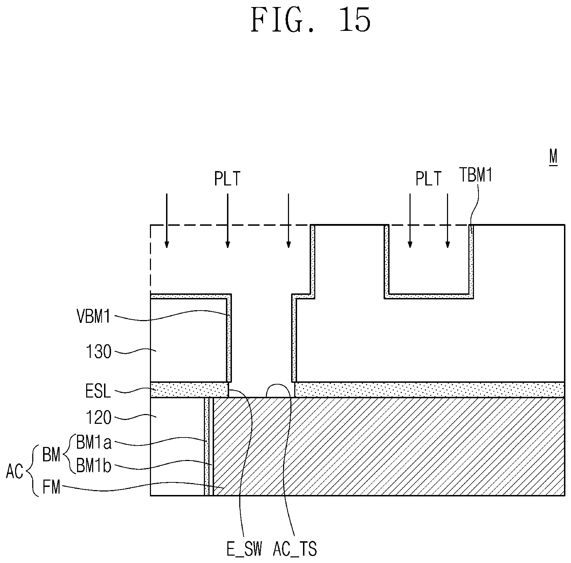

Referring to FIG. 15, a plasma treatment may be performed on the wiring hole MH, the via hole VH, and the trench hole TH. The plasma treatment may be performed on the first barrier pattern VBM1 and the blocking layer BLL. For example, the plasma process may utilize argon (Ar) ions PLT in a plasma state to treat a surface of the first barrier pattern VBM1.

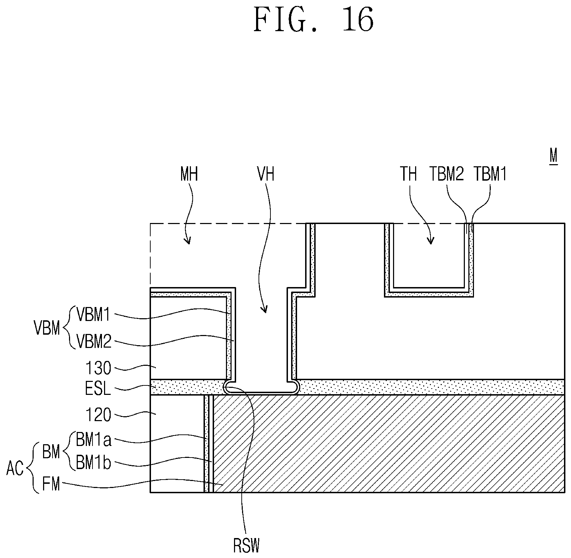

The plasma process may collide the argon (Ar) ions PLT in a plasma state at a high speed with the surface of the blocking layer BLL. As a result, the blocking layer BLL may be removed, and thus a sidewall E_ SW of the etching stop layer ESL and an upper surface AC_TS of the conductive pattern FM may be exposed. The exposed sidewall E_SW of the etching stop layer ESL may be further recessed by the plasma process. As a result, the etching stop layer ESL may include a concave sidewall facing inward (refer to the recessed sidewall RSW of FIG. 16 described later). As the etching stop layer ESL is concavely recessed, a width of a lower portion of the via hole VH may be greater than a width of an upper portion thereof.

As another example, an etching process may be additionally performed to selectively remove the blocking layer BLL before the plasma process. Through the plasma process performed thereafter, the blocking layer BLL that was not removed in the etching process may be completely removed.

Referring to FIG. 16, a second barrier pattern VBM2 may be conformally formed in the wiring hole MH, the via hole VH, and the trench hole TH. Forming the second barrier pattern VBM2 may include a chemical vapor deposition (CVD) process. The second barrier pattern VBM2 may be formed on the first barrier pattern VBM1. The second barrier pattern VBM2 may cover an upper surface of the exposed conductive pattern FM and the recessed sidewall RSW of the etching stop layer ESL. The second barrier pattern VBM2 may be formed to a lower portion of the via hole VH. The second barrier pattern VBM2 may extend to a bottom surface of the via hole VH. Therefore, the lowest level of the second barrier pattern VBM2 may be lower than the lowest level of the first barrier pattern VBM1.

The second barrier pattern VBM2 may include at least one of titanium, tantalum, tungsten, nickel, cobalt, platinum, and a combination thereof. The second barrier pattern VBM2 may include a different transition metal from that of the first barrier pattern VBM1. For example, the second barrier pattern VBM2 may not include ruthenium (Ru). The second barrier pattern VBM2 formed in the trench hole TH may be a second trench barrier pattern TBM2. The second trench barrier pattern TBM2 may be the same or substantially the same as the second barrier pattern VBM2.

Referring to FIG. 17A, a filling material may be filled in the wiring hole MH and the via hole VH to form a preliminary via conductive pattern VFM_P. A filling material may be filled in the trench hole TH to form a preliminary trench conductive pattern TFM_P. For example, depositing the filling material in the wiring hole MH, the via hole VH, and the trench hole TH, and a reflow process on the filling material may be repeatedly performed. In some example embodiments, a first filling material that is initially provided may be different from a second filling material that is provided after the reflow process. The first filling material may be an alloy including two or more metals. On the other hand, the second filling material may include only one metal. For example, the first filling material may include more of a transition metal than the second filling material.

As an example, the first filling material may be at least two metal materials selected from the group consisting of manganese, aluminum, copper, tungsten, molybdenum, and cobalt. As an example, the first filling material may be copper-manganese (CuMn). Manganese (Mn) of the first filling material may be provided at a lower portion of the via hole VH. By depositing the filling material and continuously repeating the reflow process, a via conductive pattern VFM may be formed in the via hole VH, thereby forming a first via VI1. A first power line M1_R1 may be formed in the wiring hole MH, and a first wiring line M1_I may be formed in the trench hole TH.

Referring to FIG. 17B, a post reflow anneal (PRA) process may be performed on the first via VI1. For example, an anneal process may be performed after the last reflow process of FIG. 17A. The anneal process may be performed at a temperature of about 300°C to 600°C. By the anneal process, manganese (Mn) particles PAT disposed at a lower portion of the first via VI1 may move toward the etching stop layer ESL. This is because manganese (Mn) has a greater tendency to react with oxygen (O) than copper (Cu) of the conductive pattern FM.

In the same principle, manganese (Mn) particles disposed at a lower portion of the first wiring line M1_I may move toward the third interlayer insulating layer 130. For example, manganese (Mn) particles disposed at the lower portion of the first wiring line M1_I may move to the edge of the first wiring line M1_I.

Referring to FIG. 6A again, the moved manganese (Mn) particles PAT may react with oxygen of the etching stop layer ESL to form manganese oxide (MnO). As a result, side barrier pattern SBP may be formed between the second barrier pattern VBM2 and the etching stop layer ESL. A concentration of manganese (Mn) may have a maximum value at the side barrier pattern SBP. The concentration of manganese may increase as the first via VI1 gets closer to the side barrier pattern SBP.

In the same principle, a lower barrier pattern TBP may be formed between the first trench barrier pattern TBM1 and the second trench barrier pattern VBM2. As the lower barrier pattern TBP is spaced apart from the etching stop layer ESL, a concentration of manganese oxide (MnO) may be lower than that of the side barrier pattern SBP.

According to the method of manufacturing a semiconductor device of the inventive concepts, the post reflow anneal (PRA) process may be performed to form the side barrier pattern SBP at the lower portion of the first via VI1. By the PRA process, manganese may move toward the etching stop layer ESL, and oxygen of the etching stop layer ESL and the moved manganese may react to form the side barrier pattern SBP. Accordingly profile defects of the first via and the conductive pattern may be improved.

According to the inventive concepts, the three-dimensional field effect transistor may have the side barrier pattern interposed between the lower portion of the first via and the etching stop layer. The side barrier pattern may include the transition metal oxide to limit and/or prevent the conductive material of the first via from diffusing. The first barrier pattern may be omitted from the first via at the lower portion adjacent to the conductive pattern, thereby limiting and/or preventing the conductive material of the conductive pattern from diffusing toward the first via and forming a void. As a result, the semiconductor device according to the inventive concepts may improve the reliability thereof.

According to the inventive concepts, the method of manufacturing the three-dimensional field effect transistor may form the side barrier pattern at the lower portion of the first via by performing the post reflow anneal (PRA) process. The transition metal may move toward the etching stop layer by the PRA process. The oxygen of the etching stop layer and the transition metal may react to form the side barrier pattern. Accordingly, a profile defect of the first via and the conductive pattern may be improved, and corrosion of the conductive pattern may be limited and/or prevented. As a result, the semiconductor device according to the inventive concepts may improve the electrical characteristics thereof.

While some example embodiments are described above, a person skilled in the art may understand that many modifications and variations are made without departing from the scope of the inventive concepts defined in the following claims. Accordingly, the example embodiments of the inventive concepts should be considered in all respects as illustrative and not restrictive, with the scope of the inventive concepts being indicated by the appended claims. Embodiments of the invention are set out I the following clauses:
Clause 1. A semiconductor device comprising, a transistor on a substrate, the transistor including a conductive pattern; a first metal layer on the transistor, the first metal layer including a first wiring line and a first via below the first wiring line; and an etching stop layer between the transistor and the first metal layer, wherein the first via penetrates the etching stop layer, and the first via connects the conductive pattern and the first wiring line, wherein the first via includes, a first barrier pattern, a second barrier pattern on the first barrier pattern, and a side barrier pattern between the second barrier pattern and the etching stop layer, and wherein the side barrier pattern includes a transition metal oxide.
Clause 2. The semiconductor device of clause 1, wherein the side barrier pattern includes a transition metal that is different than a transition metal of the first barrier pattern.
Clause 3. The semiconductor device of clause 1 or 2, wherein the side barrier pattern includes a transition metal that is different than a transition metal of the second barrier pattern.
Clause 4. The semiconductor device of clause 1, 2, or 3, wherein the side barrier pattern extends to a bottom surface of the second barrier pattern.
Clause 5. The semiconductor device of anyone previous clause, wherein the first via further includes a via conductive pattern, the second barrier pattern covers a sidewall of the via conductive pattern, and the second barrier pattern extends between a bottom surface of the via conductive pattern and an upper surface of the conductive pattern.
Clause 6. The semiconductor device of any one previous clause, wherein the side barrier pattern comprises a material formed by a reaction between a transition metal and oxygen of the etching stop layer.
Clause 7. The semiconductor device of any one previous clause, wherein a lower portion of the first via includes a protrusion laterally protruding toward the etching stop layer.
Clause 8. The semiconductor device of clause 7, wherein a concentration of a transition metal in the protrusion of the first via increases along a lateral direction approaching the etching stop layer.
Clause 9. The semiconductor device of any one previous clause, wherein the first barrier pattern and the conductive pattern are spaced apart from each other, with the etching stop layer being between the first barrier pattern and the conductive pattern.
Clause 10. The semiconductor device of any one previous clause, wherein the etching stop layer includes an oxide.
Clause 11. A semiconductor device comprising: a transistor on a substrate, the transistor including a conductive pattern; a first metal layer on the transistor; and an etching stop layer between the transistor and the first metal layer, wherein the first metal layer includes a first wiring line and a first via below the first wiring line, wherein the first via penetrates the etching stop layer, and the first via connects the conductive pattern and the first wiring line, wherein
the first via includes a first transition metal, and wherein a concentration of the first transition metal increases toward the etching stop layer, and the concentration of the first transition metal has a maximum value at an interface between the first via and the etching stop layer.
Clause 12. The semiconductor device of clause 11, wherein the first via comprises: a first barrier pattern; and a second barrier pattern on the first barrier pattern, and wherein the first barrier pattern and the second barrier pattern respectively include transition metals different than the first transition metal.
Clause 13. The semiconductor device of clause 12, wherein the first barrier pattern and the conductive pattern are spaced apart from each other, with the etching stop layer being between the first barrier pattern and the conductive pattern.
Clause 14. The semiconductor device of clause 12 or 13, wherein the first via further includes a side barrier pattern between the second barrier pattern and the etching stop layer, and the side barrier pattern is an oxide including the first transition metal.
Clause 15. The semiconductor device of clause 14, wherein the etching stop layer includes oxygen, and the side barrier pattern comprises a material formed by a reaction between the first transition metal and the oxygen of the etching stop layer.
Clause 16. The semiconductor device of any one of clauses 11 to 15, wherein the first metal layer further includes a second wiring line spaced apart from the etching stop layer, the second wiring line comprises, a third barrier pattern, a fourth barrier pattern on the third barrier pattern, and a lower barrier pattern between the third barrier pattern and the fourth barrier pattern, and the lower barrier pattern includes the first transition metal.
Clause 17. A semiconductor device comprising: a substrate including an active pattern; a source/drain pattern on the active pattern; a channel pattern on the active pattern, the channel pattern being connected to the source/drain pattern, and the channel pattern including a plurality of semiconductor patterns that are stacked and spaced apart from each other; a gate electrode extending in a first direction across the channel pattern; a gate insulating layer between the channel pattern and the gate electrode; a gate spacer on a sidewall of the gate electrode; a gate capping pattern on an upper surface of the gate electrode; a first interlayer insulating layer on the gate capping pattern; an active contact penetrating the first interlayer insulating layer, the active contact being connected to the source/drain pattern; a gate contact penetrating the first interlayer insulating layer, the gate contact being connected to the gate electrode; an etching stop layer on the first interlayer insulating layer; a second interlayer insulating layer on the etching stop layer; and a first metal layer in the second interlayer insulating layer, wherein the first metal layer includes a first wiring line and a first via below the first wiring line, wherein the first via connects the active contact to the first metal layer, wherein the first via includes a first barrier pattern, a second barrier pattern on the first barrier pattern, and a side barrier pattern between the second barrier pattern and the etching stop layer, and wherein the side barrier pattern is a transition metal oxide including a transition metal different than transition metals of each of the first and second barrier patterns.
Clause 18. The semiconductor device of clause 17, wherein the first via further includes a via conductive pattern, the second barrier pattern covers a sidewall of the via conductive pattern, the via conductive pattern includes a same transition metal as the transition metal of the side barrier pattern, and a concentration of the transition metal of the via conductive pattern increases toward the etching stop layer.
Clause 19. The semiconductor device of clause 17 or 18, wherein the first barrier pattern and the active contact are spaced apart from each other, with the etching stop layer being between the first barrier pattern and the active contact.
Clause 20. The semiconductor device of clause 17, 19, or 19, wherein the side barrier pattern comprises a material formed by a reaction between the transition metal and oxygen of the etching stop layer.

## Claims

1. A semiconductor device comprising:
a transistor on a substrate (100), the transistor including a conductive pattern (FM);
a first metal layer (M1) on the transistor, the first metal layer including a first wiring line (M1_I) and a first via (VI1) below the first wiring line; and
an etching stop layer (ESL) between the transistor and the first metal layer (M1),
wherein the first via (VI1) penetrates the etching stop layer (ESL), and the first via connects the conductive pattern and the first wiring line (M1_1),
wherein the first via includes:
a first barrier pattern (VBM1),
a second barrier pattern (VBM2) on the first barrier pattern, and
a side barrier pattern (SBP) between the second barrier pattern and the etching stop layer (ESL), and
wherein the side barrier pattern (SBP) includes a transition metal oxide.

2. The semiconductor device of claim 1, wherein the side barrier pattern includes a transition metal that is different than a transition metal of the first barrier pattern.

3. The semiconductor device of claim 1 or 2, wherein the side barrier pattern includes a transition metal that is different than a transition metal of the second barrier pattern.

4. The semiconductor device of claim 1, 2 or 3, wherein the side barrier pattern extends to a bottom surface of the second barrier pattern.

5. The semiconductor device as claimed in any one of claims 1 to 4, wherein
the first via further includes a via conductive pattern,
the second barrier pattern covers a sidewall of the via conductive pattern, and
the second barrier pattern extends between a bottom surface of the via conductive pattern and an upper surface of the conductive pattern.

6. The semiconductor device as claimed in any one of claims 1 to 5, wherein the side barrier pattern comprises a material formed by a reaction between a transition metal and oxygen of the etching stop layer.

7. The semiconductor device as claimed in any one of claims 1 to 6, wherein a lower portion of the first via includes a protrusion laterally protruding toward the etching stop layer, optionally wherein a concentration of a transition metal in the protrusion of the first via increases along a lateral direction approaching the etching stop layer.

8. The semiconductor device as claimed in any one of claims 1 to 8, wherein the first barrier pattern and the conductive pattern are spaced apart from each other, with the etching stop layer being between the first barrier pattern and the conductive pattern.

9. The semiconductor device as claimed in any one of claims 1 to 9, wherein the etching stop layer includes an oxide.

10. The semiconductor device as claimed in any one of claims 1 to 10, wherein a lower portion of the first via includes a first transition metal, and a concentration of the first transition metal increases toward the etching stop layer, and the concentration of the first transition metal has a maximum value at an interface between the first via and the etching stop layer.

11. A semiconductor device comprising:
a transistor on a substrate, the transistor including a conductive pattern;
a first metal layer on the transistor; and
an etching stop layer between the transistor and the first metal layer,
wherein the first metal layer includes a first wiring line and a first via below the first wiring line,
wherein the first via penetrates the etching stop layer, and the first via connects the conductive pattern and the first wiring line,
wherein a lower portion of the first via includes a first transition metal, and
wherein a concentration of the first transition metal increases toward the etching stop layer, and the concentration of the first transition metal has a maximum value at an interface between the first via and the etching stop layer.

12. The semiconductor device of claim 11, wherein the first via comprises:
a first barrier pattern; and
a second barrier pattern on the first barrier pattern, and
wherein the first barrier pattern and the second barrier pattern respectively include transition metals different than the first transition metal.

13. The semiconductor device of claim 12, wherein the first barrier pattern and the conductive pattern are spaced apart from each other, with the etching stop layer being between the first barrier pattern and the conductive pattern.

14. The semiconductor device of claim 12 or 13, wherein
the first via further includes a side barrier pattern between the second barrier pattern and the etching stop layer, and
the side barrier pattern is an oxide including the first transition metal.

15. The semiconductor device of claim 14, wherein
the etching stop layer includes oxygen, and
the side barrier pattern comprises a material formed by a reaction between the first transition metal and the oxygen of the etching stop layer.
